# EUROPEAN PATENT APPLICATION

(11) **EP 2 944 620 A1**
(43) Date of publication of application: **18.11.2015**
(21) Application number: 14873492.4
(22) Date of filing: 25.12.2014
(51) Int. Cl.: C03C 17/02, C03C 17/34, C09K 11/00, C09K 11/02, C09K 11/08

(54) **SILICA GLASS MEMBER FOR WAVELENGTH CONVERSION, AND PRODUCTION METHOD THEREFOR**

(30) Priority: 26.12.2013 JP 2013268645; 01.08.2014 JP 2014157754; 01.08.2014 JP 2014157758; 10.09.2014 JP 2014184093
(71) Applicant: Shin-Etsu Quartz Products Co., Ltd., Tokyo 160-0023 (JP)
(72) Inventor: MORI, Tatsuya, Koriyama-shi Fukushima 963-0725 (JP); SATO, Tatsuhiro, Tokyo 160-0023 (JP); FUJINOKI, Akira, Tokyo 160-0023 (JP)
(74) Representative: Grünecker Patent- und Rechtsanwälte PartG mbB
(86) International application number: PCT/JP2014/084398
(87) International publication number: WO 2015/099084

(57) **Abstract**

Provided are a quartz glass member for wavelength conversion that is high in environmental resistance, heat resistance, durability, and color rendering property, can be manufactured by a low-temperature process, and can efficiently convert a wavelength, and a method of manufacturing the same.

The quartz glass member for wavelength conversion includes: a quartz glass base material; and a quartz glass surface layer film formed on a surface of the quartz glass base material, in which: the quartz glass surface layer film is obtained by applying, onto the surface of the quartz glass base material, a polysilazane-containing solution containing fluorescent material particles having an average particle diameter of from 0.1 µm to 20 µm and silica fine particles each having a spherical shape and hydrophobicity and having an average particle diameter of from 1 nm to 100 nm, followed by drying in air and then heat treatment in a water vapor atmosphere; the polysilazane-containing solution has a ratio between a total amount of polysilazane and the fluorescent material particles and the fluorescent material particles of from 10:3 to 10:7 in terms of mass; and the quartz glass surface layer film has an NH group concentration of 1,000 ppm or less.

## Description

### Technical Field

The present invention relates to a quartz glass member for wavelength conversion for absorbing part of emitted light and then emitting light through wavelength conversion, and to a method of manufacturing the same. The present invention also relates to a quartz glass member for wavelength conversion for absorbing part of emitted light and then emitting light through wavelength conversion, the quartz glass member being provided with a function of preventing adhesion of an organic material on a surface of the member and a function of blocking ultraviolet rays, and to a method of manufacturing the same.

### Background Art

A wavelength conversion material converts a certain wavelength of light, and allows light having a wavelength longer than the wavelength to be extracted therefrom depending on a utilization application, and thereby improves efficiency.

In recent years, in a general solar cell, electric energy has been generated by directly radiating solar light to a silicon crystal and thereby causing excitation. However, light in an ultraviolet wavelength region contained in the solar light changes into heat, resulting in an energy loss. In addition, energy of the solar light to be utilized is collected in a large amount, and hence a calorific intensity in the collected portion is extremely increased. Therefore, a material that can resist high temperature has been demanded. In consequence, there has been a demand for a wavelength conversion material made of quartz glass that can efficiently convert an ultraviolet wavelength component of solar light to a longer wavelength component and thereby improve power generation efficiency of the solar cell, and can resist high temperature as well.

Next, a technical example in the technical field of laser oscillation is described. For excitation of a Nd:YAG laser having high output power, a xenon flash lamp is generally used. The lamp has light emission over a broad range of from 200 nm to 1,000 nm, but light required for the excitation of the Nd:YAG laser is light having a wavelength of from 530 nm to 550 nm or from 580 nm to 600 nm. Therefore, light in an ultraviolet region is used in vain to cause an energy loss. Accordingly, if ultraviolet rays can be utilized as light having a wavelength useful for the Nd:YAG laser through wavelength conversion, light emission efficiency of the laser can be improved. Also in this field, there has been a demand for a material utilizing quartz as a material that can resist high temperature and ultraviolet rays.

In addition, an LED chip for emitting blue light or ultraviolet rays using a compound semiconductor has been developed, and an attempt has been made to develop a light emitting device for emitting light such as white light through wavelength conversion of light of the LED chip by use of the chip and various fluorescent materials in combination. Such light emitting device has merits of small size, light weight, and electric power saving. Also in this field, there has been a demand for a material utilizing quartz as a material that can resist high temperature and ultraviolet rays. In addition, in the applications related to light, in-plane uniformity of a light emission intensity is an important demand characteristic.

Further, in recent years, an LED has been used as a lighting device for a plant factory instead of a fluorescent lamp. Light having various wavelengths is required for growth of a plant depending on a kind of the plant or its growth stage, and in general, visible light is suitable. Also in this field, there has been a demand for a material utilizing quartz as a material that is excellent in wavelength conversion efficiency, water resistance, and chemical resistance.

Meanwhile, as a related-art wavelength conversion material for a solar cell, there have been disclosed a sealing material that has an organic metal complex for absorbing ultraviolet light and emitting light in a visible region blended in a resin and thereby improves conversion efficiency of a solar cell, and a solar cell having the sealing material (Patent Documents 1 and 2).

However, there is a problem in that the organic metal complex to be utilized in Patent Documents 1 and 2 has poor light resistance and hence is deteriorated through continuous irradiation with light, resulting in a reduction in conversion efficiency. Further, owing to the use of the resin in the sealing material, there is a problem of yellowing of the resin.

As a wavelength conversion material for a xenon flash lamp to be utilized for the excitation of the Nd:YAG laser, there has been disclosed a material that has copper doped into silica glass and thereby converts ultraviolet rays to visible light (Patent Document 3).

However, a method disclosed in Patent Document 3 has problems from the viewpoints of reducing cost and an environmental load because the method includes a manufacturing step of a high temperature process and requires an expensive manufacturing facility.

As a related-art blue or ultraviolet LED light emitting device, there is given a light emitting device in which an LED chip is surrounded by a protective resin containing a fluorescent material and the whole is further surrounded by a sealing resin.

However, by the related-art method using the resin containing a fluorescent material, the covering resins (protective resin and sealing resin) are deteriorated by ultraviolet rays generated by the LED chip. It is generally known that the protective resin and the sealing resin, which are each formed of an organic polymer compound in which elements such as carbon, hydrogen, oxygen, and nitrogen are bonded to form a network structure, are deteriorated in various optical characteristics and chemical characteristics through irradiation with ultraviolet rays owing to the network structure of the organic polymer being cut.

Further, there has been known a method involving mixing a fluorescent material in a solution containing a polysiloxane composition precursor, applying the solution, and performing heating, and thereby sealing the fluorescent material in silica glass (Patent Document 4). However, the polysiloxane composition precursor often has an organic functional group, and hence when heating is performed, a gas, cracks, and the like are liable to be generated through decomposition of the organic functional group. In addition, production of the silica glass from the polysiloxane composition precursor needs complicated steps including hydrolysis, polycondensation, drying, and sintering, and hence there is a problem of difficulty in mass production.

In the plant factory, water and a fertilizer are heavily used. Therefore, an LED lighting device utilizing such resin having sealed therein a fluorescent material as described above is not suitable for this application owing to high water vapor permeability and low chemical resistance.

In each of the related-art examples, there is a problem in that, in the case where excited light to be used includes ultraviolet rays having a wavelength of 400 nm or less, the ultraviolet rays pass through the wavelength conversion material and then are radiated to a target object, and thereby have various adverse influences thereon such as deterioration and a chemical reaction.

In addition, there are problems of significant reductions in function as follows: dust, metal element particles, grit of an organic material, and the like in an atmosphere adhere and attach onto a surface of the wavelength conversion material as the material continues to be used, with the results that converted light is reflected, scattered, or absorbed and thus is not emitted from the wavelength conversion material, and that micro particles fly from the surface owing to a reduction in strength of a surface portion.

### Prior Art Documents

### Patent Document

Patent Document 1: WO 2008/047427 A1
Patent Document 2: JP 2010-258293 A
Patent Document 3: JP 2005-272243 A
Patent Document 4: WO 2010/110204 A1

### Summary of the Invention

### Problems to be solved by the invention

The present invention has been made in view of the above-mentioned problems of the related art, and a first object of the present invention is to provide a quartz glass member for wavelength conversion that is high in environmental resistance, heat resistance, durability, and color rendering property, can be manufactured by a low-temperature process, and can efficiently convert a wavelength, and a method of manufacturing the same.

A second object of the present invention is to provide a quartz glass member for wavelength conversion that prevents leakage of ultraviolet rays, is excellent in environmental resistance, heat resistance, durability, surface antifouling property, surface stability, uniformity of a light emission intensity, and color rendering property, can be manufactured by a low-temperature process, and can efficiently convert a wavelength, and a method of manufacturing the same.

Further, a third object of the present invention is to provide a quartz glass member for wavelength conversion that prevents leakage of ultraviolet rays, is excellent in environmental resistance, stability of a light emission intensity, heat resistance, durability, surface antifouling property, surface stability, uniformity of the light emission intensity, and color rendering property, can be manufactured by a low-temperature process, and can efficiently convert a wavelength, and a method of manufacturing the same.

### Means for Solving Problems

In order to achieve the above-mentioned objects, the inventors of the present invention have made extensive investigations on a method of manufacturing a quartz glass member for wavelength conversion capable of manufacturing a quartz glass member by a low-temperature process by using a quartz glass surface layer film excellent in environmental resistance, heat resistance, and durability and fluorescent material particles. As a result, the present invention has been accomplished.

According to a first aspect of the present invention, there is provided a quartz glass member for wavelength conversion, including: a quartz glass base material; and a quartz glass surface layer film formed on a surface of the quartz glass base material, in which: the quartz glass surface layer film is obtained by applying, onto the surface of the quartz glass base material, a polysilazane-containing solution containing fluorescent material particles having an average particle diameter of from 0.1 µm to 20 µm and silica fine particles each having a spherical shape and hydrophobicity and having an average particle diameter of from 1 nm to 100 nm, followed by drying in air and then heat treatment in a water vapor atmosphere; the polysilazane-containing solution has a ratio between a total amount of polysilazane and the fluorescent material particles and the fluorescent material particles of from 10:3 to 10:7 in terms of mass; and the quartz glass surface layer film has an NH group concentration of 1,000 ppm or less.

In the quartz glass member for wavelength conversion according to the aspect of the present invention, it is preferred that the quartz glass surface layer film has a thickness of from 1 µm to 500 µm.

It is preferred that quartz glass to be used in the quartz glass base material includes synthetic quartz glass. It is more preferred that the quartz glass base material includes synthetic quartz that is generated by flame hydrolysis of a silicon tetrachloride compound and has an OH group concentration of from 10 ppm to 1,000 ppm.

According to a first aspect of the present invention, there is provided a method of manufacturing a quartz glass member for wavelength conversion, including: forming a quartz glass surface layer film on a surface of a quartz glass base material by applying, onto the quartz glass base material, a polysilazane-containing solution containing fluorescent material particles having an average particle diameter of from 0.1 µm to 20 µm and 0.1 mass% to 10 mass% of silica fine particles each having a spherical shape and hydrophobicity and having an average particle diameter of from 1 nm to 100 nm, followed by heating in a water vapor atmosphere, the polysilazane-containing solution having a ratio between a total amount of polysilazane and the fluorescent material particles and the fluorescent material particles of from 10:3 to 10:7 in terms of mass.

It is preferred that the forming a quartz glass surface layer film includes repeating a plurality of times quartz glass surface layer film formation treatment of applying the polysilazane-containing solution onto the quartz glass base material, followed by drying in air and then heating in a water vapor atmosphere at a temperature of from 100°C to 600°C to form a quartz glass surface layer film having a thickness of from 0.1 µm to 10 µm, to form the quartz glass surface layer film having a laminate structure and having a thickness of from 1 µm to 500 µm.

According to a second aspect of the present invention, there is provided a quartz glass member for wavelength conversion, including: a quartz glass base material; a wavelength conversion quartz glass layer formed on a surface of the quartz glass base material, the wavelength conversion quartz glass layer containing fluorescent material particles; and a transparent coating film formed on a surface of the wavelength conversion quartz glass layer.

It is preferred that the transparent coating film includes a transparent inorganic film.

It is preferred that the transparent inorganic film includes a Ti-containing inorganic film.

It is preferred that the Ti-containing inorganic film contains titanium oxide in an anatase crystal form.

It is preferred that the quartz glass member for wavelength conversion further includes an intermediate quartz glass layer formed between the wavelength conversion quartz glass layer and the transparent coating film, the intermediate quartz glass layer having a concentration of fluorescent material particles of approximately from 10% to 60% of a concentration of the fluorescent material particles in the wavelength conversion quartz glass layer. When the intermediate quartz glass layer is formed as described above, there is an advantage in that the transparent coating film is less liable to be peeled off.

It is preferred that the quartz glass base material includes synthetic quartz glass. This is because the synthetic quartz glass is excellent in transmission characteristic of ultraviolet rays.

It is preferred that the quartz glass base material includes quartz glass containing one or more selected from the group consisting of Ga, Ce, Cu, and Ti. This is because the incorporation of those elements provides an effect of absorbing the ultraviolet rays.

It is preferred that the quartz glass base material includes light scattering quartz glass having micro bubbles and/or a micro interface. This is because, when the quartz glass base material includes the light scattering quartz glass having micro bubbles and/or a micro interface, light is uniformly dispersed.

According to a second aspect of the present invention, there is provided a method of manufacturing the quartz glass member for wavelength conversion, including: forming the transparent coating film by applying, onto the surface of the wavelength conversion quartz glass layer or a surface of the intermediate quartz glass layer, a solution containing silica and/or a silica precursor to form a thin film coating, followed by drying and then heating.

It is preferred that the transparent coating film and the wavelength conversion quartz glass layer are each formed by a sol-gel method. For example, in the case of synthesizing silica by a sol-gel method, silica may be synthesized by subjecting a sol containing a silica precursor such as TEOS to a hydrolysis and polycondensation reaction and thereby converting the sol into a gel state.

It is preferred that the method of manufacturing a quartz glass member for wavelength conversion includes the steps of: forming the wavelength conversion quartz glass layer on the surface of the quartz glass base material by applying, onto the quartz glass base material, a polysilazane-containing solution containing fluorescent material particles having an average particle diameter of from 0.1 µm to 20 µm and silica fine particles each having a spherical shape and hydrophobicity and having an average particle diameter of from 1 nm to 100 nm, followed by drying in air and then heat treatment in a water vapor atmosphere; and forming the transparent coating film on the surface of the wavelength conversion quartz glass layer, the polysilazane-containing solution having a ratio between a total amount of polysilazane and the fluorescent material particles and the fluorescent material particles of from 10:1 to 10:9 in terms of mass, the wavelength conversion quartz glass layer having an NH group concentration of 1,000 ppm or less.

It is preferred that the method of manufacturing a quartz glass member for wavelength conversion includes the steps of: forming the wavelength conversion quartz glass layer on the surface of the quartz glass base material by applying, onto the quartz glass base material, a TEOS (Tetra Ethyl Ortho Silicate) hydrolysis solution prepared by mixing fluorescent material particles having an average particle diameter of from 0.1 µm to 20 µm, water, and TEOS, followed by drying in air; and forming the transparent coating film on the surface of the wavelength conversion quartz glass layer, the TEOS hydrolysis solution having a ratio between a total amount of TEOS and the fluorescent material particles and the fluorescent material particles of from 10:1 to 10:9 in terms of mass.

In addition, it is preferred that the Ti-containing inorganic film is formed by applying, onto the surface of the wavelength conversion quartz glass layer, a solution containing Ti to form a coating, followed by sintering.

According to a third aspect of the present invention, there is provided a quartz glass member for wavelength conversion, including: a quartz glass base material; and a wavelength conversion quartz glass layer formed on a surface of the quartz glass base material, the wavelength conversion quartz glass layer containing fluorescent material particles, in which the wavelength conversion quartz glass layer has a fluorescent material concentration distributed from a high concentration to a low concentration from a glass base material side toward a wavelength conversion quartz glass layer surface side.

As described above, when the wavelength conversion quartz glass layer has a fluorescent material concentration distributed from a higher concentration to a lower concentration from the glass base material side toward the wavelength conversion quartz glass layer surface side, its thermal conductivity becomes higher in the vicinity of the quartz glass base material. Therefore, heat energy generated by a silicon single crystal or LED element placed inside the glass base material or arranged in contact with the glass base material is easily emitted outside. In consequence, overheating of the silicon single crystal or LED element is suppressed, and a reduction in power generation efficiency or light emission efficiency is avoided.

It is preferred that the wavelength conversion quartz glass layer has a laminate structure, contains a plurality of kinds of fluorescent materials, and be formed by laminating a plurality of layers by using a different kind of fluorescent material for each of the plurality of layers. The fluorescent materials have different average particle sizes and different densities from each other. Therefore, in order to uniformly disperse and laminate the fluorescent materials, it is necessary to perform the lamination under conditions appropriate for each of the fluorescent materials. With this, uniform light emission intensity distribution can be obtained. When the lamination conditions are not changed, the fluorescent materials are distributed unevenly, and the uniform light emission intensity distribution cannot be obtained. When such quartz glass member for wavelength conversion according to the aspect of the present invention is used for a glass sealing portion of an element related to light such as an LED element, a uniform in-plane light emission intensity can be obtained.

It is preferred that the quartz glass base material includes synthetic quartz glass. This is because the synthetic quartz glass is excellent in transmission characteristic of ultraviolet rays.

In addition, it is preferred that the quartz glass base material includes quartz glass containing one or more selected from the group consisting of Ga, Ce, Cu, and Ti. This is because the incorporation of those elements provides an effect of absorbing the ultraviolet rays.

It is preferred that the quartz glass base material includes light scattering quartz glass having micro bubbles and/or a micro interface. This is because, when the quartz glass base material includes the light scattering quartz glass having micro bubbles and/or a micro interface, light is uniformly dispersed.

It is preferred that the quartz glass member for wavelength conversion further includes a transparent coating film formed on the surface of the wavelength conversion quartz glass layer.

It is preferred that the transparent coating film includes a transparent inorganic film.

It is preferred that the transparent inorganic film includes a Ti-containing inorganic film.

It is preferred that the Ti-containing inorganic film contains titanium oxide in an anatase crystal form.

It is preferred that the quartz glass member for wavelength conversion further includes an intermediate quartz glass layer formed between the wavelength conversion quartz glass layer and the transparent coating film, the intermediate quartz glass layer having a concentration of fluorescent material particles of approximately from 10% to 60% of a concentration of the fluorescent material particles in the wavelength conversion quartz glass layer. When the intermediate quartz glass layer is formed as described above, the difference in degree of thermal expansion between the transparent coating film and the wavelength conversion quartz glass layer is alleviated. As a result, there is an advantage in that the peeling of the transparent coating film due to the difference in amount of thermal expansion at the time of heating hardly occurs.

According to a third aspect of the present invention, there is provided a method of manufacturing the quartz glass member for wavelength conversion, the method including: forming the transparent coating film by applying a solution containing silica and/or a silica precursor to form a thin film coating, followed by drying and then heating.

It is preferred that the transparent coating film and the wavelength conversion quartz glass layer are each formed by a sol-gel method.

It is preferred that the Ti-containing inorganic film is formed by applying, onto the surface of the wavelength conversion quartz glass layer, a solution containing Ti to form a coating, followed by sintering.

In addition, according to a third aspect of the present invention, there is provided a method of manufacturing the quartz glass member for wavelength conversion, the method including the steps of: forming the wavelength conversion quartz glass layer on the surface of the quartz glass base material by applying, onto the quartz glass base material, a polysilazane-containing solution containing fluorescent material particles having an average particle diameter of from 0.1 µm to 20 µm and silica fine particles each having a spherical shape and hydrophobicity and having an average particle diameter of from 1 nm to 100 nm, followed by drying in air and then heat treatment in a water vapor atmosphere; and further forming a transparent coating film on a surface of the wavelength conversion quartz glass layer, the polysilazane-containing solution having a ratio between a total amount of polysilazane and the fluorescent material particles and the fluorescent material particles of from 10:1 to 10:9 in terms of mass, the wavelength conversion quartz glass layer having an NH group concentration of 1,000 ppm or less.

It is preferred that the forming the quartz conversion glass surface layer includes repeating a plurality of times wavelength conversion quartz glass layer formation treatment of applying the polysilazane-containing solution onto the quartz glass base material, followed by drying in air and then heating in a water vapor atmosphere at a temperature of from 100°C to 600°C to form a wavelength conversion quartz glass layer having a thickness of from 0.1 µm to 10 µm, to form the wavelength conversion quartz glass layer having a laminate structure and having a thickness of from 1 µm up to 500 µm.

In addition, according to a third aspect of the present invention, there is provided a method of manufacturing the quartz glass member for wavelength conversion, including the steps of forming the wavelength conversion quartz glass layer on the surface of the quartz glass base material by preparing a solution in which the fluorescent material particles having an average particle diameter of from 0.1 µm to 20 µm and water are mixed in a TEOS hydrolysis solution, followed by applying the solution onto the quartz glass base material and then drying in air; and forming a transparent coating film on a surface of the wavelength conversion quartz glass layer, the TEOS hydrolysis solution having a ratio between a total amount of TEOS and the fluorescent material particles and the fluorescent material particles of from 10:1 to 10:9 in terms of mass.

It is preferred that the forming the wavelength conversion quartz glass layer includes repeating a plurality of times wavelength conversion quartz glass layer formation treatment of applying the TEOS hydrolysis solution onto the quartz glass base material, followed by drying in air and then heating at from 300°C to 1,000°C to form a wavelength conversion quartz glass layer having a thickness of from 0.1 µm to 10 µm, to form the wavelength conversion quartz glass layer having a laminate structure and having a thickness of from 1 µm up to 500 µm.

It is preferred that the wavelength conversion quartz glass layer is formed by laminating layers so that fluorescent material concentrations of the layers are adjusted from a high concentration to a low concentration from the quartz glass base material toward the transparent coating film.

It is preferred that the wavelength conversion quartz glass layer contains a plurality of kinds of fluorescent materials, and be formed by laminating a plurality of layers by using a different kind of fluorescent material for each of the plurality of layers.

### Advantageous Effects of the Invention

According to the first aspect of the present invention, the following remarkable effect is exhibited: it is possible to provide the quartz glass member for wavelength conversion that is high in environmental resistance, heat resistance, durability, and color rendering property, can be manufactured by a low-temperature process, and can efficiently convert a wavelength, and the method of manufacturing the same.

According to the second and third aspects of the present invention, the following remarkable effect is exhibited: it is possible to provide the quartz glass member for wavelength conversion that prevents leakage of ultraviolet rays, is excellent in environmental resistance, heat resistance, durability, surface antifouling property, surface stability, uniformity of a light emission intensity, and color rendering property, can be manufactured by a low-temperature process, and can efficiently convert a wavelength, and the method of manufacturing the same.

The quartz glass member for wavelength conversion according to the aspects of the present invention can be suitably used for a glass sealing portion of an element related to light such as an LED element.

### Brief Description of Drawings

FIG. 1 is a schematic sectional view for illustrating a quartz glass member for wavelength conversion according to one embodiment of a first aspect of the present invention.
FIG. 2 is a chromaticity diagram for showing results of measuring the chromaticity of quartz glass members for wavelength conversion produced in Examples 1 and 2 according to the first aspect of the present invention with a simplified spectrometer.
FIG. 3 is a schematic sectional view for illustrating a quartz glass member for wavelength conversion according to one embodiment of a second aspect of the present invention.
FIG. 4 is a schematic sectional view for illustrating a quartz glass member for wavelength conversion according to another embodiment of the second aspect of the present invention.
FIG. 5 is a chromaticity diagram for showing results of measuring the chromaticity of quartz glass members for wavelength conversion produced in Examples and Comparative Example according to the second aspect of the present invention with a light emission spectrometer.
FIG. 6 is a spectral spectrum for showing results of measuring the spectra of the quartz glass members for wavelength conversion produced in Example and Comparative Example according to the second aspect of the present invention with a light emission spectrometer.
FIG. 7 is a schematic sectional view for illustrating a quartz glass member for wavelength conversion according to one embodiment of a third aspect of the present invention.
FIG. 8 is a schematic sectional view for illustrating a quartz glass member for wavelength conversion according to another embodiment of the third aspect of the present invention.
FIG. 9 is a chromaticity diagram for showing results of measuring the chromaticity of quartz glass members for wavelength conversion produced in Examples and Comparative Example according to the third aspect of the present invention with a light emission spectrometer.
FIG. 10 is a spectral spectrum for showing results of measuring the spectra of the quartz glass members for wavelength conversion produced in Example and Comparative Example according to the third aspect of the present invention with a light emission spectrometer.

### Modes for Carrying out the Invention

Embodiments of the present invention are described below with reference to the attached drawings. It goes without saying that illustrated examples are merely described as examples and various modifications may therefore be made without departing from the technical concept of the present invention.

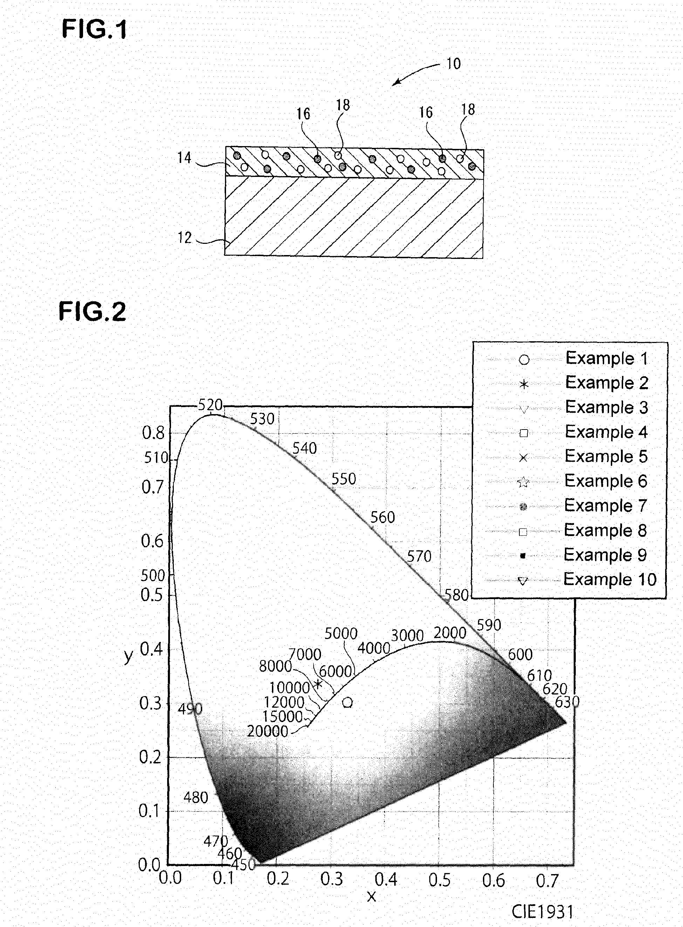

FIG. 1 is a schematic sectional view for illustrating a quartz glass member for wavelength conversion according to one embodiment of a first aspect of the present invention. In FIG. 1, a quartz glass member 10 for wavelength conversion is the quartz glass member for wavelength conversion of the present invention. The quartz glass member 10 for wavelength conversion includes a quartz glass base material 12 and a quartz glass surface layer film 14 formed on the surface of the quartz glass base material 12. The quartz glass surface layer film 14 contains fluorescent material particles 16 and silica fine particles 18.

### [Quartz Glass Surface Layer Film]

The concentration of the fluorescent material particles in the quartz glass surface layer film is preferably as follows: a polysilazane-containing solution has a ratio between the total amount of polysilazane and the fluorescent material particles and the fluorescent material particles of from 10:3 to 10:7 in terms of mass. That is, when the total amount of polysilazane and the fluorescent material particles is defined as 10 parts by mass, the amount of the fluorescent material particles is preferably from 3 parts by mass to 7 parts by mass. In addition, the ratio between the the total amount of polysilazane and the fluorescent material particles and the fluorescent material particles is more preferably from 10:5 to 10:7 in terms of mass.

When the concentration of the fluorescent material particles is low, the number of times of lamination needs to be increased accordingly, and hence the number of operation procedures is increased. When the concentration of the fluorescent material particles is too high, light from a light source hardly enters inside, resulting in a reduction in light emission efficiency. The concentration of NH groups remaining in the quartz glass surface layer film is 1,000 ppm or less, preferably 100 ppm or less. When the concentration is equal to or less than the value, coloration does not occur and cracks are not generated even through long-term irradiation with ultraviolet rays or exposure to high temperature.

The thickness of the quartz glass surface layer film is preferably from 1 µm to 500 µm. The thickness of the quartz glass surface layer film is more preferably 10 µm or more and 100 µm or less. When the thickness is less than 1 µm, light from the light source is transmitted, resulting in a reduction in wavelength conversion efficiency. Besides, in the case of using ultraviolet rays as the light source, the harmful ultraviolet rays are radiated. On the other hand, when the thickness exceeds 500 µm, the number of times of lamination is increased, resulting in an increase in manufacturing cost.

### [Quartz Glass Base Material]

The quartz glass base material to be used in the quartz glass member for wavelength conversion according to the first aspect of the present invention is formed of preferably synthetic quartz glass, particularly preferably synthetic quartz glass produced by subjecting silicon tetrachloride to flame hydrolysis. The synthetic quartz glass produced by such method contains impurities such as a metal impurity in small amounts, and deterioration such as coloration does not occur even through long-term irradiation with ultraviolet rays. In addition, the synthetic quartz glass has an extremely low thermal expansion coefficient, and hence generation of cracks resulting from heat treatment can be suppressed. Further, ultraviolet rays from the light source are not attenuated by virtue of a high transmittance of ultraviolet rays, and hence the fluorescent material can emit light efficiently. The synthetic quartz glass produced by the method has an OH group concentration of from 10 ppm to 1,000 ppm.

### [Method of Forming Quartz Glass Surface Layer Film]

The quartz glass surface layer film containing the fluorescent material particles and the silica fine particles is produced by subjecting the polysilazane-containing solution containing the fluorescent material particles and the silica fine particles to drying and heating in a water vapor atmosphere.

In the quartz glass member for wavelength conversion according to the first aspect of the present invention, the quartz glass surface layer film is formed by heat treatment in the water vapor atmosphere, and hence the NH group concentration in the quartz glass surface layer film is reduced. The heat treatment in the water vapor atmosphere eliminates the need for a heating furnace or the like, and enables manufacturing by a low-temperature process.

The fluorescent material particles to be used in the quartz glass member for wavelength conversion according to the first aspect of the present invention have an average particle diameter of from 0.1 µm to 20 µm. The average particle diameter is more preferably from 1 µm to 10 µm. When the fluorescent material particles have an average particle diameter of less than 0.1 µm, the surface areas thereof are increased, and along with this, light is more strongly scattered, resulting in a reduction in light emission intensity. In contrast, when the fluorescent material particles have a size exceeding 20 µm, the formed surface layer film has uneven light emission chromaticity and an uneven light emission intensity.

As the fluorescent material particles, fluorescent material particles that are excited by ultraviolet rays having a wavelength of from 200 nm to 400 nm and can convert the ultraviolet rays to visible light are preferred, and any marketed product commercially available can be used. Specific examples thereof include: Sr₁₀(PO₄)₆Cl₂:Eu²⁺, CaS:Bi, CaSrS:Bi, and Ba₁₋ₐEuₐMgAl₁₀O₁₇ as a blue fluorescent material; ZnS:Cu,Al, Ba₂SiO₄:Eu, and ZnGe₂O₄:Eu as a green fluorescent material; and Y₂O₂S:Eu³⁺, CaS:Eu, 3.5MgO·0.5MgF₂·GeO₂:Mn, and K₅Eu_{2.5}(WO₄) as a red fluorescent material.

The silica fine particles to be used in the quartz glass member for wavelength conversion according to the first aspect of the present invention preferably have a composition of synthetic quartz glass particles. Such synthetic quartz glass surface layer film forms a dense silica film after the heat treatment. Accordingly, the utilization of the synthetic quartz glass particles as inorganic oxide particles in view of compatibility of refractive index and thermal expansion coefficient enables suppression of a color variation and cracks.

When such silica fine particles are incorporated into the quartz glass surface layer film, the silica fine particles each act as aggregate, and a film having a large thickness can be formed at one time without generation of cracks at the time of lamination of the quartz glass surface layer films.

The silica fine particles to be used in the quartz glass member for wavelength conversion according to the first aspect of the present invention have an average particle diameter of from 1 nm to 100 nm. The average particle diameter is preferably from 3.0 nm to 80 nm, more preferably from 5.0 nm to 50 nm. When the silica fine particles have an average particle diameter of less than 1 nm, the particles themselves are difficult to obtain. Even if such particles are obtained, the particles immediately agglomerate owing to large surface energy. In contrast, when the silica fine particles have an average particle diameter exceeding 100 nm, light is strongly scattered, resulting in a reduction in light utilization efficiency of an LED.

The silica fine particles to be used in the quartz glass member for wavelength conversion according to the first aspect of the present invention each have a spherical shape and hydrophobicity. When a liquid containing the silica fine particles is applied onto the quartz glass base material to form a coating, the liquid needs to have flowability. When the silica fine particles to be used each do not have a spherical shape, the flowability of the liquid is lost, and the coating cannot be formed uniformly. In addition, by virtue of the hydrophobicity, the silica fine particles are well dispersed in the polysilazane-containing solution, and a film in which the silica fine particles are uniformly dispersed can be obtained.

The concentration of the silica fine particles is preferably as follows: the polysilazane-containing solution has a ratio between the total amount of polysilazane, the fluorescent material particles, and the silica fine particles and the silica fine particles of from 10:0.01 to 10:1 in terms of mass. That is, when the total amount of polysilazane, the fluorescent material particles, and the silica fine particles is defined as 10 parts by mass, the amount of the silica fine particles is preferably from 0.01 part by mass to 1 part by mass. The ratio between the total amount of polysilazane, the fluorescent material particles, and the silica fine particles and the silica fine particles is more preferably from 10:0.05 to 10:0.5 in terms of mass. When the concentration of the silica fine particles is too low, the action as aggregate is lost. When the concentration of the silica fine particles is too high, diffuse reflection is caused, resulting in a reduction in light extraction efficiency.

In the production of the quartz glass surface layer film, a perhydropolysilazane solution is preferably used as a polysilazane solution. When other silazane compounds or alkoxysilanes are utilized, cracks are generated owing to the presence of an organic functional group because the organic functional group is decomposed at the time of heating in a water vapor atmosphere. Further, perhydropolysilazane is free of an organic functional group, and hence enables water vapor firing at low temperature because perhydropolysilazane is converted to silica without providing energy for combusting an organic material. When perhydropolysilazane is fired in a water vapor atmosphere, perhydropolysilazane constructed only of Si, N, and H changes into quartz glass constructed of Si and O.

In the production of the quartz glass surface layer film, it is preferred that a coating liquid containing the polysilazane solution, the silica fine particles, and the fluorescent material particles is dried at a temperature of, for example, from 100°C to 200°C to vaporize most of an organic solvent, and then subjected to firing in a water vapor atmosphere. The production of the quartz glass surface layer film can be accomplished in a firing time period of from about 10 seconds to 30 minutes, while the firing time period depends on the thickness of the quartz glass surface layer film. For example, a quartz glass surface layer film having a thickness of 1 µm can be produced at 600°C in a water vapor atmosphere in 10 seconds.

Perhydropolysilazane in the perhydropolysilazane solution as the polysilazane solution causes the following reaction.

(SiH₂NH)+2H₂O→SiO₂+NH₃+2H₂

The reaction proceeds to the right in the presence of water. Therefore, perhydropolysilazane can be converted to silica even in a short time period and at low temperature through heating in water vapor. In the firing of perhydropolysilazane in a water vapor atmosphere, a Si-N bond in its skeleton changes into a Si-O bond. At this time, the molecular weight of a basic structural unit increases, and hence a denser and harder film can be obtained.

The firing temperature for forming the quartz glass surface layer film in water vapor is preferably from 100°C to 600°C. When the firing temperature is too high, the fluorescent material undergoes thermal deactivation, resulting in a reduction in light emission intensity. When the firing temperature is too low, the water vapor is not diffused inside, and besides, the reaction is not caused sufficiently.

Herein, in the case of laminating the quartz glass surface layer films, the thickness per film is preferably from 0.1 pm to 10 µm, more preferably from 0.5 µm to 10 µm, still more preferably from 0.5 µm to 5 µm. When the thickness per film is less than 0.1 µm, it takes a long time to form the quartz glass surface layer films, resulting in an increase in manufacturing cost. In contrast, when a film having a thickness exceeding 10 µm is formed at one time, cracks are generated at the time of the firing owing to generation of a gas resulting from the reaction. The quartz glass surface layer films are formed until the films as a whole achieve such a thickness as to contain a desired amount of the fluorescent material by repeating such lamination treatment. Thus, the quartz glass surface layer film having a laminate structure and having a thickness of from 1 µm to 500 µm can be formed.

The quartz glass surface layer film having a laminate structure and having a thickness of from 1 µm up to 500 µm may be formed by repeating a plurality of times quartz glass surface layer film formation treatment of applying the polysilazane-containing solution onto the quartz glass base material, followed by drying in the air and then heating in a water vapor atmosphere at a temperature of 100°C or more and 600°C or less to form the quartz glass surface layer film having a thickness of from 0.1 µm to 10 µm. Perhydropolysilazane can reduce the number of times of formation treatment, simplify an operation, and realize a reduction in manufacturing cost, as compared to other materials. A wet coating method such as a spray method, a spin coating method, a dip coating method, or a roll coating method may be used for the formation of the quartz glass surface layer film.

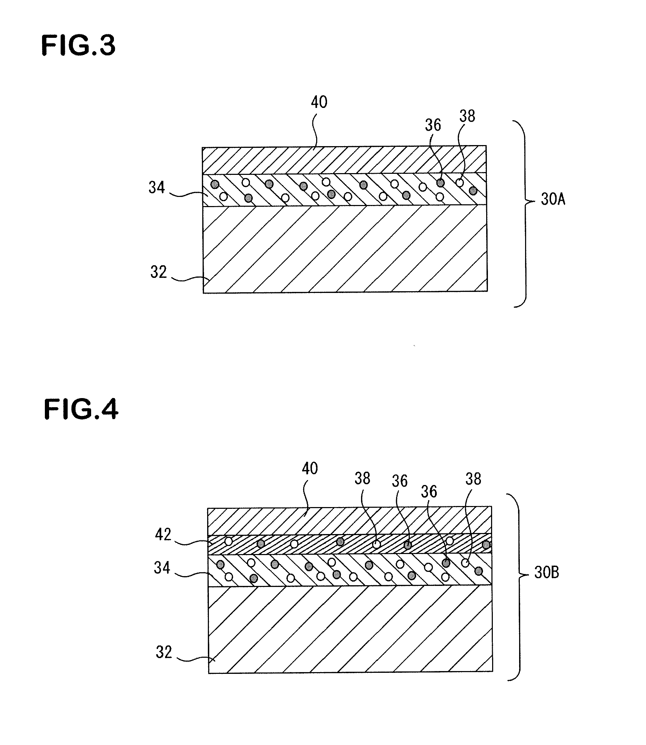

Next, a schematic sectional view for illustrating a quartz glass member for wavelength conversion according to one embodiment of a second aspect of the present invention is illustrated in FIG. 3.

In FIG. 3, a quartz glass member 30A for wavelength conversion is the quartz glass member for wavelength conversion of the present invention. The quartz glass member 30A for wavelength conversion includes a quartz glass base material 32, a wavelength conversion quartz glass layer 34 that is formed on the surface of the quartz glass base material 32 and contains fluorescent material particles 36, and a transparent coating film 40 formed on the surface of the wavelength conversion quartz glass layer 34. The wavelength conversion quartz glass layer 34 further contains silica fine particles 38.

In addition, a schematic sectional view for illustrating a quartz glass member for wavelength conversion according to another embodiment of the second aspect of the present invention is illustrated in FIG. 4.

In FIG. 4, a quartz glass member 30B for wavelength conversion is the quartz glass member for wavelength conversion of the present invention. The quartz glass member 30B for wavelength conversion includes the quartz glass base material 32, the wavelength conversion quartz glass layer 34 that is formed on the surface of the quartz glass base material 32 and contains the fluorescent material particles 36, and the transparent coating film 40 formed on the surface of the wavelength conversion quartz glass layer 34. The quartz glass member 30B for wavelength conversion further includes, between the wavelength conversion quartz glass layer 34 and the transparent coating film 40, an intermediate quartz glass layer 42 having a concentration of fluorescent material particles of approximately from 10% to 60% of the concentration of the fluorescent material particles 36 in the wavelength conversion quartz glass layer 34. In addition, in the illustrated example, the intermediate quartz glass layer 42 has a concentration of silica fine particles of approximately from 10% to 60% of the concentration of the silica fine particles 38 in the wavelength conversion quartz glass layer 34.

### [Transparent Coating Film]

The transparent coating film is formed on the surface of the wavelength conversion quartz glass layer. The transparent coating film can prevent deactivation of the fluorescent material in the wavelength conversion quartz glass layer caused in contact with a metal element in the external atmosphere or in contact with, for example, S or an oxidizing gas, and prevent generation of cracks and particles resulting from a change in volume in association with oxidation or sulfurization of the fluorescent material. The transparent coating film is preferably a transparent inorganic film, more preferably a Ti-containing inorganic film. The transparent coating film is preferably a quartz glass coating film, but a coating film formed of general glass such as borosilicate glass, or ceramic may be adopted. In use at low temperature, a silicone film may also be used.

Next, the transparent coating film preparing step is described.

In a first aspect of the transparent coating film preparing step, the transparent coating film preparing step includes the steps of applying a silica slurry onto the wavelength conversion quartz glass layer, performing heating treatment in an oxidizing atmosphere in the temperature region of from 300°C to 1,200°C, and sintering the resultant within the temperature range of from 1,000°C to 1,400°C.

In the first aspect of the transparent coating film preparing step, the silica slurry is a silica slurry prepared from silica particles each having a particle diameter of from 0.1 µm to 100 µm, preferably from 0.5 µm to 50 µm, so as to have a concentration of silica of from 50% to 95%, preferably from 60% to 80%, and a concentration of a cellulose derivative of from 0.05% to 10%, preferably from 0.1% to 5%. Examples of the cellulose derivative include methylcellulose, hydroxypropylmethylcellulose, and hydroxymethylcellulose. Of those, methylcellulose is preferred.

A method of applying the silica slurry is not particularly limited. Spin coating may also be employed to form a coating with a uniform thickness. After the application, the resultant is dried in the range of from ordinary temperature to 300°C.

The heating treatment in the oxidizing atmosphere includes heating treatment in, for example, an oxygen atmosphere or an air atmosphere in the temperature region of from 300°C to 1,200°C, preferably from 500°C to 1,000°C to decompose and remove organic components such as carbon. A heating treatment time period is not particularly limited, but is preferably from 0.5 hour to 100 hours, more preferably from 2 hours to 40 hours.

When the quartz glass member is used in a semiconductor production process, the quartz glass member is required to have a high purity, and hence a purification step is introduced after the above-mentioned treatment. That is, heating treatment is performed in an atmosphere containing chlorine, preferably in a HCl gas, in the temperature range of from 800°C to 1,400°C, preferably from 1,000°C to 1,200°C.

In the sintering treatment, the coating layer is sintered in the temperature range of from 1,000°C to 1,400°C, preferably from 1,100°C to 1,300°C. A sintering time period is not particularly limited, but is preferably from 0.2 hour to 20 hours, more preferably from 1 hour to 10 hours.

The transparent quartz glass portion after the sintering contains metal impurities at a total content of 70 ppm or less (including 0), preferably 50 ppm or less, more preferably 30 ppm or less. When the content of metal impurities exceeds 70 ppm, the amount of metal impurities to be released from the surface increases, and in particular, the quartz glass member is unsuitable as a quartz glass material to be used in a semiconductor production process and causes an electrical abnormality in the produced semiconductor device. When the content is 30 ppm or less, no problem arises.

On the other hand, the concentration of carbon becomes 30 ppm or less, preferably 20 ppm or less, more preferably 1.0 ppm or less. Carbon, like metal impurities, is considered as a cause of an electric abnormality in the produced semiconductor device in the semiconductor production process, and when its concentration exceeds 30 ppm, the quartz glass member is unsuitable as a quartz glass material to be used in the semiconductor production process. When the concentration is 10 ppm or less, no problem arises.

The thickness of the formed transparent coating film is preferably from 1 µm to 1,000 µm, more preferably from 5 µm to 100 µm. When the thickness is less than 1 µm, a coating effect is not exhibited. When the thickness exceeds 1,000 µm, bubbles are generated in the film in a large amount, which causes cracks and particles.

In a second aspect of the transparent coating film preparing step, the transparent coating film preparing step includes the steps of applying a silica slurry onto the wavelength conversion quartz glass layer, performing heating treatment in an oxidizing atmosphere in the temperature region of from 300°C to 1,200°C, and sintering the resultant within the temperature range of 800°C or more and 1,200°C or less.

In the second aspect of the transparent coating film preparing step, the silica slurry is a silica slurry prepared from silica particles each having a particle diameter of from 1 nm to 100 nm, preferably from 2 nm to 50 nm, so as to have a concentration of silica of from 1% to 50%, preferably from 10% to 30%, and a concentration of an organic binder of from 0.05% to 10%, preferably from 0.1% to 5%. Examples of the organic binder include cellulose-based binders (methylcellulose, carboxymethylcellulose, and hydroxyethyl alcohol), agar, vinyl-based binders (polyvinyl alcohol and polyvinylpyrrolidone), starch-based binders (dialdehyde starch, dextrin, and polylactic acid), acrylic binders (sodium polyacrylate and methyl methacrylate), and viscous substances of plant origin. Of those, polyvinyl alcohol or methylcellulose is suitable.

In the second aspect of the transparent coating film preparing step, a method of applying the silica slurry and the heating treatment in the oxidizing atmosphere may be performed in the same manner as in the first aspect of the transparent coating film preparing step.

The temperature range in the sintering treatment is from 800°C to 1,150°C, preferably from 900°C to 1,100°C. As the particle diameter of each silica particle reduces, the lability of a particle surface increases and Si-O, Si·, Si-Hx, and Si-CHx in the particle surface react at lower temperature to be converted to Si-O-Si, resulting in a transparent glass. The sintering only needs to be performed at the same pressure and for the same sintering time period as those in the first aspect of the transparent coating film preparing step.

The total concentration of metal impurities and concentration of carbon contained in the transparent quartz glass portion obtained by the second aspect of the transparent coating film preparing step are the same as those in the transparent quartz glass portion obtained by the first aspect of the transparent coating film preparing step.

In a third aspect of the transparent coating film preparing step, the transparent coating film preparing step is performed by a method including applying a polysilazane-containing solution containing silica fine particles to form a thin film coating, followed by drying and then heating in a water vapor atmosphere. The thickness of the formed transparent coating film is preferably from 1 µm to 1,000 µm, more preferably from 5 µm to 100 µm. When the thickness is less than 1 µm, the coating effect is not exhibited. When the thickness exceeds 1,000 µm, bubbles are generated in the film in a large amount, which causes cracks and particles.

The transparent coating film is formed at a sintering temperature of from 100°C to 1,000°C, preferably 200°C or more and 900°C or less. With this, the deactivation of the fluorescent material can be prevented.

More specifically, the transparent coating film is preferably prepared by a manufacturing method including the steps of: forming the wavelength conversion quartz glass layer on the surface of the quartz glass base material by applying, onto the quartz glass base material, a polysilazane-containing solution containing fluorescent material particles having an average particle diameter of from 0.1 µm to 20 µm and silica fine particles each having a spherical shape and hydrophobicity and having an average particle diameter of from 1 nm to 100 nm, followed by drying in the air and then heat treatment in a water vapor atmosphere; and forming the transparent coating film on the surface of the wavelength conversion quartz glass layer. In the method, the polysilazane-containing solution has a ratio between the total amount of polysilazane and the fluorescent material particles and the fluorescent material particles of from 10:1 to 10:9 in terms of mass, and the wavelength conversion quartz glass layer has an NH group concentration of 1,000 ppm or less.

In addition, the transparent coating film may also be prepared by a sol-gel method.

In a fourth aspect of the transparent coating film preparing step, the transparent coating film preparing step is performed by a method including applying a slurry using as a raw material a TEOS hydrolysis solution or the like to form a thin film coating, followed by sintering. The thickness of the formed transparent coating film is preferably from 1 µm to 1,000 µm, more preferably from 5 µm to 100 µm. When the thickness is 1 µm or less, the coating effect is not exhibited. When the thickness is 1,000 µm or more, bubbles are generated in the film in a large amount, which causes cracks and particles. The sintering temperature is from 300°C to 1,000°C, preferably from 400°C to 900°C. With this, the deactivation of the fluorescent material can be suppressed.

More specifically, the transparent coating film is preferably prepared by a manufacturing method including the steps of: forming the wavelength conversion quartz glass layer on the surface of the quartz glass base material by applying, onto the quartz glass base material, a TEOS hydrolysis solution prepared by mixing fluorescent material particles having an average particle diameter of from 0.1 µm to 20 µm, water, and TEOS, followed by drying in the air; and forming the transparent coating film on the surface of the wavelength conversion quartz glass layer. In the method, the TEOS hydrolysis solution has a ratio between the total amount of TEOS and the fluorescent material particles and the fluorescent material particles of from 10:1 to 10:9 in terms of mass.

In a fifth aspect of the transparent coating film preparing step, the transparent coating film preparing step is performed by a method including applying a silica slurry using as a raw material colloidal silica or the like to form a thin film coating, followed by sintering. The thickness of the formed transparent coating film is preferably from 1 µm to 1,000 µm, more preferably from 5 µm to 100 µm. When the thickness is less than 1 µm, the coating effect is not exhibited. When the thickness is exceeds 1,000 µm, bubbles are generated in the film in a large amount, which causes cracks and particles. The sintering temperature is from 800°C to 1,300°C, preferably from 900°C to 1,200°C. With this, the deactivation of the fluorescent material can be suppressed to some extent.

### [Ti-containing Inorganic Film]

The Ti-containing inorganic film, which is preferably used as the transparent coating film, is a thin film formed of titanium oxide in an anatase crystal form or a thin film including such titanium oxide at a high concentration. The thickness of the film falls within a range of preferably from 0.1 µm to 20 µm, more preferably from 1 µm to 5 µm. When the thickness is less than 0.1 µm, the absorption rate of ultraviolet rays of 300 nm or less is reduced. When the thickness is exceeds 20 µm, transmission of light having a wavelength of 400 nm or more is significantly reduced.

In the case where ultraviolet rays having a wavelength of 388 nm or less emitted from excited light are transmitted through the quartz glass base material and the wavelength conversion quartz glass layer, the ultraviolet rays are absorbed and prevented from leaking to the outside. Besides, with their energy, active oxygen (superoxide ion and hydroxyl radical), which exhibits a strong oxidative degradation action, is generated to cause a photocatalytic reaction. With this, the surface of the Ti-containing inorganic film is cleaned by, for example, purification of an organic material adhering onto the surface, oxidative degradation removal of fouling, or sterilization of bacteria. With this, long-wavelength light generated in the wavelength conversion quartz glass layer through wavelength conversion is transmitted and radiated without being absorbed or reflected by the organic material adhering onto the surface.

The Ti-containing inorganic film is formed by applying a metal alkoxide containing Ti onto the surface of the wavelength conversion quartz glass layer to form a coating, followed by sintering. Specifically, a hydrolysis solution obtained by dissolving titanium tetraisopropoxide (Ti(OCH(CH₃)₂)₄ in isopropyl alcohol (2-propanol) (CH₃CHOHCH₃) is applied onto the surface of a target base material to form a coating, and the coating is subjected to heating and firing in a temperature range of from 200°C to 1,000°C. When the temperature is less than 200°C, the anatase-type titanium oxide crystal is not generated after the firing. When the temperature is exceeds 900°C, a rutile-type titanium oxide crystal having a low photocatalytic activity is generated. The temperature is preferably from 500°C to 800°C.

Other than the above-mentioned method, there may be adopted: an application method involving applying a titanium oxide powder slurry or the like onto a base, followed by firing; a method involving applying a marketed anatase sol onto the base; a sputtering method involving sputtering an oxide target in high vacuum to form the film; a CVD method involving allowing an organic material or a halide to be volatilized and decomposed in an electric furnace to form the film; a plasma spraying method involving melting solid particles in plasma generated in the air, and beating the solid particles onto the surface of the base; or the like.

### [Wavelength Conversion Quartz Glass Layer]

In a first aspect of a wavelength conversion quartz glass layer preparing step to be used for the quartz glass member for wavelength conversion according to the second aspect of the present invention, the wavelength conversion quartz glass layer preparing step is performed by a method including subjecting the polysilazane-containing solution containing fluorescent material particles and silica fine particles to drying and heating in a water vapor atmosphere.

More specifically, the wavelength conversion quartz glass layer is preferably prepared by the manufacturing method including the steps of: forming the wavelength conversion quartz glass layer on the surface of the quartz glass base material by applying, onto the quartz glass base material, the polysilazane-containing solution containing fluorescent material particles having an average particle diameter of from 0.1 µm to 20 µm and silica fine particles each having a spherical shape and hydrophobicity and having an average particle diameter of from 1 nm to 100 nm, followed by drying in the air and then heat treatment in a water vapor atmosphere; and forming the transparent coating film on the surface of the wavelength conversion quartz glass layer. In the method, the polysilazane-containing solution has a ratio between the total amount of polysilazane and the fluorescent material particles and the fluorescent material particles of from 10:1 to 10:9 in terms of mass, and the wavelength conversion quartz glass layer has an NH group concentration of 1,000 ppm or less.

When the wavelength conversion quartz glass layer is formed by heat treatment in the water vapor atmosphere, the NH group concentration in the wavelength conversion quartz glass layer is reduced. The heat treatment in the water vapor atmosphere eliminates the need for a heating furnace or the like, and enables manufacturing by a low-temperature process.

The average particle diameter of the fluorescent material particles to be used in the present invention is preferably from 0.1 µm to 20 µm. The average particle diameter is more preferably from 1 µm to 10 µm. When the fluorescent material particles have an average particle diameter of less than 0.1 µm, the surface areas thereof are increased, and along with this, light is more strongly scattered, resulting in a reduction in light emission intensity. In contrast, when the fluorescent material particles have a size exceeding 20 µm, the formed film has uneven light emission chromaticity and an uneven light emission intensity.

As the fluorescent material particles, fluorescent material particles that are excited by ultraviolet rays having a wavelength of from 200 nm to 400 nm and can convert the ultraviolet rays to visible light are preferred, and any marketed product commercially available can be used. Specific examples thereof include: Sr₁₀(PO₄)₆Cl₂:Eu²⁺, CaS:Bi, CaSrS:Bi, and Ba₁₋ₐEuₐMgAl₁₀O₁₇ as a blue fluorescent material; ZnS:Cu,Al, Ba₂SiO₄:Eu, and ZnGe₂O₄:Eu as a green fluorescent material; Y₂O₂S:Eu³⁺, CaS:Eu, 3.5MgO·0.5MgF₂·GeO₂:Mn, and K₅Eu_{2.5}(WO₄) as a red fluorescent material.

The silica fine particles to be used in the present invention preferably have a composition of synthetic quartz glass particles. Such wavelength conversion synthetic quartz glass layer forms a dense silica film after the heat treatment. Accordingly, the utilization of the synthetic quartz glass particles as inorganic oxide particles in view of compatibility of refractive index and thermal expansion coefficient enables suppression of a color variation and cracks.

When such silica fine particles are incorporated into the wavelength conversion quartz glass layer, the silica fine particles each act as aggregate, and a film having a large thickness can be formed at one time without generation of cracks at the time of lamination of the wavelength conversion quartz glass layers.

The silica fine particles to be used in the quartz glass member for wavelength conversion according to the second aspect of the present invention have an average particle diameter of from 1 nm to 100 nm. The average particle diameter is preferably from 3.0 nm to 80 nm, more preferably from 5.0 nm to 50 nm. When the silica fine particles have an average particle diameter of less than 1 nm, the particles themselves are difficult to obtain. Even if such particles are obtained, the particles immediately agglomerate owing to large surface energy. In contrast, when the silica fine particles have an average particle diameter exceeding 100 nm, light is scattered excessively strongly, resulting in a reduction in light utilization efficiency of an LED.

The silica fine particles to be used in the present invention each have a spherical shape and hydrophobicity. When a liquid containing the silica fine particles is applied onto the quartz glass base material to form a coating, the liquid needs to have flowability. When the silica fine particles to be used each do not have a spherical shape, the flowability of the liquid is lost, and the coating cannot be formed uniformly. In addition, by virtue of the hydrophobicity, the silica fine particles are well dispersed in the polysilazane-containing solution, and a film in which the silica fine particles are uniformly dispersed can be obtained.

The concentration of the silica fine particles is preferably as follows: the polysilazane-containing solution has a ratio between the total amount of polysilazane, the fluorescent material particles, and the silica fine particles and the silica fine particles of from 10:0.01 to 10:1 in terms of mass. That is, when the total amount of polysilazane, the fluorescent material particles, and the silica fine particles is defined as 10 parts by mass, the amount of the silica fine particles is preferably from 0.01 part by mass to 1 part by mass. The ratio between the total amount of polysilazane, the fluorescent material particles, and the silica fine particles and the silica fine particles is more preferably from 10:0.05 to 10:0.5 in terms of mass. When the concentration of the silica fine particles is too low, the action as aggregate is lost. When the concentration of the silica fine particles is too high, diffuse reflection is caused, resulting in a reduction in light extraction efficiency.

In the production of the wavelength conversion quartz glass layer, a perhydropolysilazane solution is preferably used as a polysilazane solution. When other silazane compounds or alkoxysilanes are utilized, cracks are generated owing to the presence of an organic functional group because the organic functional group is decomposed at the time of heating in a water vapor atmosphere. Further, perhydropolysilazane is free of an organic functional group, and hence enables water vapor firing at low temperature because perhydropolysilazane is converted to silica without providing energy for combusting an organic material. When perhydropolysilazane is fired in a water vapor atmosphere, perhydropolysilazane constructed only of Si, N, and H changes into quartz glass constructed of Si and O.

In the production of the wavelength conversion quartz glass layer, it is preferred that a coating liquid containing the polysilazane solution, the silica fine particles, and the fluorescent material particles is dried at a temperature of, for example, from 100°C to 200°C to vaporize most of an organic solvent, and then subjected to firing in a water vapor atmosphere. The production of the wavelength conversion quartz glass layer can be accomplished in a firing time period of from about 10 seconds to 30 minutes, while the firing time period depends on the thickness of the wavelength conversion quartz glass layer. For example, a wavelength conversion quartz glass layer having a thickness of 1 µm can be produced at 600°C in a water vapor atmosphere in 10 seconds.

Perhydropolysilazane in the perhydropolysilazane solution as the polysilazane solution causes the following reaction.

(SiH₂NH)+2H₂O→SiO₂+NH₃+2H₂

The reaction proceeds to the right in the presence of water. Therefore, perhydropolysilazane can be converted to silica even in a short time period and at low temperature through heating in water vapor. In the firing of perhydropolysilazane in a water vapor atmosphere, a Si-N bond in its skeleton changes into a Si-O bond. At this time, the molecular weight of a basic structural unit increases, and hence a denser and harder film can be obtained.

The firing temperature for forming the wavelength conversion quartz glass layer in water vapor is preferably from 100°C to 1,000°C, more preferably from 200°C to 900°C. When the firing temperature is too high, the fluorescent material undergoes thermal deactivation, resulting in a reduction in light emission intensity. When the firing temperature is too low, the water vapor is not diffused inside, and the reaction is not caused sufficiently.

Herein, in the case of laminating the wavelength conversion quartz glass layers, the thickness per layer is preferably from 0.1 µm to 10 µm, more preferably from 0.5 µm to 10 µm, still more preferably from 0.5 µm to 5 µm. When the thickness per layer is less than 0.1 µm, it takes a long time to form the wavelength conversion quartz glass layers, resulting in an increase in manufacturing cost. In contrast, when a layer having a thickness exceeding 10 µm is formed at one time, cracks are generated at the time of the firing owing to generation of a H₂ gas resulting from the reaction. The wavelength conversion quartz glass layers are formed until the layers as a whole achieve such a thickness as to contain a desired amount of the fluorescent material by repeating such lamination treatment. Thus, the wavelength conversion quartz glass layer having a laminate structure and having a thickness of from 1 µm to 500 µm can be formed.

The wavelength conversion quartz glass layer having a laminate structure and having a thickness of from 1 µm up to 500 µm may be formed by repeating a plurality of times wavelength conversion quartz glass layer formation treatment of applying the polysilazane-containing solution onto the quartz glass base material, followed by drying in the air and then heating in a water vapor atmosphere at a temperature of 100°C or more and 600°C or less to form the wavelength conversion quartz glass layer having a thickness of from 0.1 µm to 10 µm. Perhydropolysilazane can reduce the number of times of formation treatment, simplify an operation, and realize a reduction in manufacturing cost, as compared to other materials. A wet coating method such as a spray method, a spin coating method, a dip coating method, or a roll coating method may be used for the formation of the wavelength conversion quartz glass layer.

The concentration of the fluorescent material particles in the wavelength conversion quartz glass layer is preferably as follows: the polysilazane-containing solution has a ratio between the total amount of polysilazane and the fluorescent material particles and the fluorescent material particles of from 10:3 to 10:7 in terms of mass. That is, when the total amount of polysilazane and the fluorescent material particles is defined as 10 parts by mass, the amount of the fluorescent material particles is preferably from 3 parts by mass to 7 parts by mass. In addition, the ratio between the total amount of polysilazane and the fluorescent material particles and the fluorescent material particles is more preferably from 10:5 to 10:7 in terms of mass.

When the concentration of the fluorescent material particles is low, the number of times of lamination needs to be increased accordingly, and hence the number of operation procedures is increased. When the concentration of the fluorescent material particles is too high, light from a light source hardly enters inside, resulting in a reduction in light emission efficiency. The concentration of NH groups remaining in the wavelength conversion quartz glass layer is 1,000 ppm or less, preferably 100 ppm or less. When the NH group concentration is equal to or less than the value, coloration does not occur and cracks are not generated even through long-term irradiation with ultraviolet rays or exposure to high temperature.

The thickness of the wavelength conversion quartz glass layer is preferably from 1 µm to 500 µm. The thickness of the wavelength conversion quartz glass layer is more preferably 10 µm or more and 100 µm or less. When the thickness is less than 1 µm, light from the light source is transmitted, resulting in a reduction in wavelength conversion efficiency. Besides, in the case of using ultraviolet rays as the light source, the harmful ultraviolet rays are radiated. On the other hand, when the thickness exceeds 500 µm, the number of times of lamination is increased, resulting in an increase in manufacturing cost.

In a second aspect of the wavelength conversion quartz glass layer preparing step to be used for the quartz glass member for wavelength conversion according to the second aspect of the present invention, the wavelength conversion quartz glass layer is produced by a method including preparing a solution in which the fluorescent material particles and water are mixed in a TEOS hydrolysis solution, applying the solution onto the surface of the quartz glass base material, followed by drying and then heating.

More specifically, the wavelength conversion quartz glass layer is preferably prepared by a manufacturing method including the steps of: forming the wavelength conversion quartz glass layer on the surface of the quartz glass base material by applying, onto the quartz glass base material, a TEOS hydrolysis solution prepared by mixing fluorescent material particles having an average particle diameter of from 0.1 µm to 20 µm, water, and TEOS, followed by drying in the air; and forming the transparent coating film on the surface of the wavelength conversion quartz glass layer. In the method, the TEOS hydrolysis solution has a ratio between the total amount of TEOS and the fluorescent material particles and the fluorescent material particles of from 10:1 to 10:9 in terms of mass.

The TEOS hydrolysis solution is prepared by mixing tetraethoxysilane, ethanol, and a trace amount of nitric acid, followed by stirring for about 1 hour. The TEOS hydrolysis solution preferably has a fraction in a range of: tetraethoxysilane (from 0.5 mol to 2 mol); ethanol (from 2 mol to 5 mol); and a trace amount of nitric acid (from 0.0005 mol to 0.01 mol).

The TEOS hydrolysis solution, fluorescent material fine particles similar to those described in the first aspect, and water are stirred with a homogenizer. The stirred solution is preferably in a range of: 1 mol to 4 mol of the TEOS hydrolysis solution; 0.5 mol to 3 mol of the fluorescent fine material particles; and 5 mol to 20 mol of water.

The stirred solution is applied onto the surface of the quartz glass base material to form a wavelength conversion quartz glass layer having a thickness of from 0.1 µm to 10 µm, preferably from 1 µm to 5 µm, and then dried at a temperature of from 0°C to 200°C, preferably from room temperature to 100°C in the air atmosphere. Then, this layer formation treatment is repeated a plurality of times, to form the wavelength conversion quartz glass layer having a laminate structure and having a thickness of from 1 µm to 500 µm, preferably from 10 µm up to 300 µm. The quartz glass member after the lamination is heated at a temperature of from 300°C to 1,000°C, preferably from 400°C to 900°C in the air.

When the layer formation treatment for the wavelength conversion quartz glass layer is repeated a plurality of times, a solution having a high fluorescent material concentration is used for a layer close to the surface of the quartz glass base material and a solution having a lower fluorescent material concentration is used as the number of times of lamination increases. Thus, the wavelength conversion quartz glass layer having a laminate structure is formed. The high-concentration layer close to the quartz glass base material has a high thermal conductivity, and hence can efficiently conduct heat from the quartz glass base material having high temperature in use and suppress heating. The low-concentration layer close to the surface has increased stability as quartz glass, and generation of cracks and particles due to the influence of heating or the external atmosphere is suppressed. When the total amount of silica and the fluorescent material particles in the formed wavelength conversion quartz glass layer is defined as 10 parts by mass, the amount of the fluorescent material particles is from 6 parts by mass to 9 parts by mass, preferably from 7 parts by mass to 9 parts by mass in the high-concentration layer close to the quartz glass base material, and the amount of the fluorescent material particles is from 1 part by mass to 5 parts by mass, preferably from 1 part by mass to 2 parts by mass in the low-concentration layer close to the surface.

When the lamination is performed by repeating the layer formation treatment for the wavelength conversion quartz glass layer a plurality of times, a plurality of layers are formed by preparing a solution containing a single fluorescent material for a single layer. With this, uniform fluorescent material distribution and uniform light emission are obtained in each layer, and the light emission intensity is uniformized in the whole surface of an outermost layer. When the layer formation treatment is performed by using a solution prepared by mixing different fluorescent materials, the fluorescent materials are liable to be distributed non-uniformly in the layer owing to a difference in specific gravity between the fluorescent materials, and the light emission intensity is not uniformized in an area of a surface layer.

### [Quartz Glass Base Material]

The quartz glass base material to be used in the present invention is formed of preferably synthetic quartz glass, particularly preferably synthetic quartz glass produced by subjecting silicon tetrachloride to flame hydrolysis. The synthetic quartz glass produced by such method contains impurities such as a metal impurity in small amounts, and deterioration such as coloration does not occur even through long-term irradiation with ultraviolet rays. In addition, the synthetic quartz glass has an extremely low thermal expansion coefficient, and hence generation of cracks resulting from the heat treatment can be suppressed. Further, ultraviolet rays from the light source are not attenuated by virtue of a high transmittance of ultraviolet rays, and hence the fluorescent material can emit light efficiently. The synthetic quartz glass produced by the method preferably has an OH group concentration of from 10 ppm to 1,000 ppm.

Other than the above, natural quartz glass, general glass, translucent ceramics, a translucent fluoride compound, or the like is adopted for the base material.

In addition, when the quartz glass base material is formed of quartz glass containing one or more selected from the group consisting of Ga, Ce, Cu, and Ti, ultraviolet rays are not transmitted therethrough. Therefore, in the case where excited light contains light in an ultraviolet region, ultraviolet rays can be prevented from leaking to the outside. The concentrations of the metal elements are each preferably from 1 ppm to 1,000 ppm, preferably from 10 ppm to 500 ppm.

Further, when the quartz glass base material is formed of light scattering quartz glass having micro bubbles and/or micro interfaces, excited light is moderately scattered. Further, at a reaching stage to the wavelength conversion quartz glass layer, the excited light has a uniform surface distribution intensity, and light emission excited in the wavelength conversion quartz glass layer has increased uniformity. The density of the micro bubbles and/or the micro interfaces is desirably as follows: the density of bubbles each having a size of 100 µm or less is preferably from 1×10² bubbles/cm³ to 1×10⁹ bubbles/cm³, more preferably from 1×10³ bubbles/cm³ to 1×10⁸ bubbles/cm³.

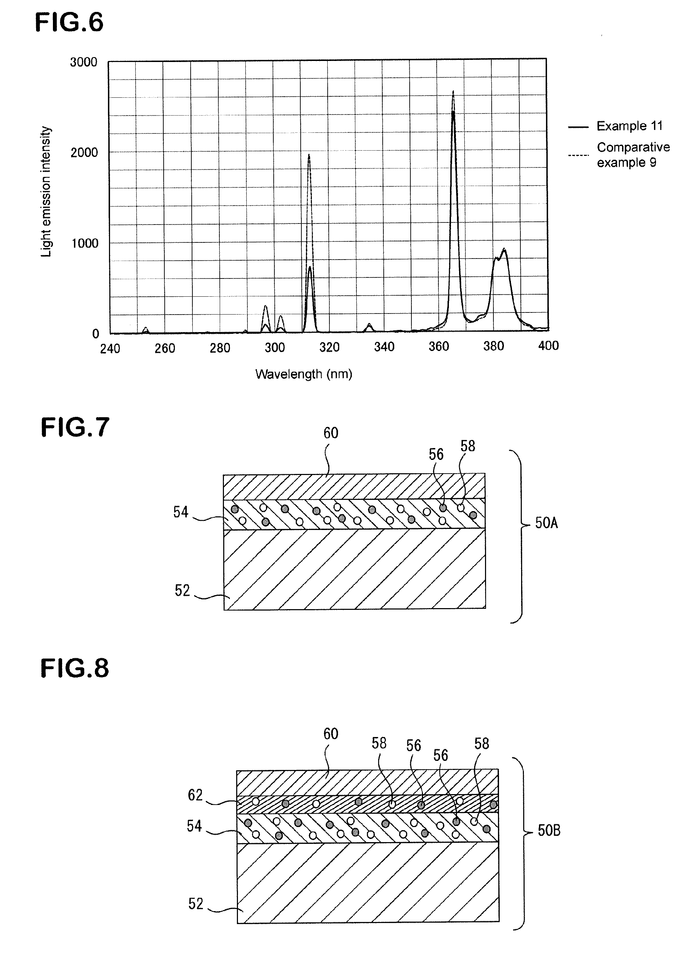

Next, a schematic sectional view for illustrating a quartz glass member for wavelength conversion according to one embodiment of a third aspect of the present invention is illustrated in FIG. 7.

In FIG. 7, a quartz glass member 50A for wavelength conversion is the quartz glass member for wavelength conversion according to one embodiment of the third aspect of the present invention. The quartz glass member 50A for wavelength conversion includes a quartz glass base material 52, a wavelength conversion quartz glass layer 54 that is formed on the surface of the quartz glass base material 52 and contains fluorescent material particles 56, and a transparent coating film 60 formed on the surface of the wavelength conversion quartz glass layer 54. The wavelength conversion quartz glass layer 54 further contains silica fine particles 58. In addition, the wavelength conversion quartz glass layer 54 has a fluorescent material concentration distributed from a high concentration to a low concentration from the quartz glass base material 52 side toward the wavelength conversion quartz glass layer 54 surface side.

In addition, a quartz glass member for wavelength conversion according to another embodiment of the third aspect of the present invention is illustrated in FIG. 8.

In FIG. 8, a quartz glass member 50B for wavelength conversion is the quartz glass member for wavelength conversion according to another embodiment of the third aspect of the present invention. The quartz glass member 50B for wavelength conversion includes the quartz glass base material 52, the wavelength conversion quartz glass layer 54 that is formed on the surface of the quartz glass base material 52 and contains the fluorescent material particles 56, and the transparent coating film 60 formed on the surface of the wavelength conversion quartz glass layer 54. The quartz glass member 50B for wavelength conversion further includes, between the wavelength conversion quartz glass layer 54 and the transparent coating film 60, an intermediate quartz glass layer 62 having a concentration of fluorescent material particles of approximately from 10% to 60% of the concentration of the fluorescent material particles 56 in the wavelength conversion quartz glass layer 54. In addition, in the illustrated example, the intermediate quartz glass layer 62 has a concentration of silica fine particles of approximately from 10% to 60% of the concentration of the silica fine particles 58 in the wavelength conversion quartz glass layer 54. In addition, the wavelength conversion quartz glass layer 54 has a fluorescent material concentration distributed from a high concentration to a low concentration from the quartz glass base material 52 side toward the wavelength conversion quartz glass layer 54 surface side.

### [Transparent Coating Film]

In the quartz glass member for wavelength conversion according to the third aspect of the present invention, a transparent coating film similar to the transparent coating film in the quartz glass member for wavelength conversion according to the second aspect of the present invention described above may be adopted as the transparent coating film. In addition, a transparent coating film preparing step for the quartz glass member for wavelength conversion according to the third aspect of the present invention is similar to the transparent coating film preparing step for the quartz glass member for wavelength conversion according to the second aspect of the present invention described above.

### [Wavelength Conversion Quartz Glass Layer]

In a first aspect of the wavelength conversion quartz glass layer preparing step to be used for the quartz glass member for wavelength conversion according to the third aspect of the present invention, the wavelength conversion quartz glass layer preparing step is performed by a method including subjecting the polysilazane-containing solution containing fluorescent material particles and silica fine particles to drying and heating in a water vapor atmosphere.

More specifically, the wavelength conversion quartz glass layer is preferably prepared by the manufacturing method including the steps of forming the wavelength conversion quartz glass layer on the surface of the quartz glass base material by applying, onto the quartz glass base material, the polysilazane-containing solution containing fluorescent material particles having an average particle diameter of from 0.1 µm to 20 µm and silica fine particles each having a spherical shape and hydrophobicity and having an average particle diameter of from 1 nm to 100 nm, followed by drying in the air and then heat treatment in a water vapor atmosphere; and forming the transparent coating film on the surface of the wavelength conversion quartz glass layer. In the method, the polysilazane-containing solution has a ratio between the total amount of polysilazane and the fluorescent material particles and the fluorescent material particles of from 10:1 to 10:9 in terms of mass, and the wavelength conversion quartz glass layer has an NH group concentration of 1,000 ppm or less.

It is preferred that the wavelength conversion quartz glass layer having a laminate structure and having a thickness of from 1 µm up to 500 µm is formed by repeating a plurality of times wavelength conversion quartz glass layer formation treatment of applying the polysilazane-containing solution onto the quartz glass base material, followed by drying in the air and then heating in a water vapor atmosphere at a temperature of 100°C or more and 600°C or less to form a wavelength conversion quartz glass layer having a thickness of from 0.1 µm to 10 µm.

When the wavelength conversion quartz glass layer is formed by heat treatment in the water vapor atmosphere, the NH group concentration in the wavelength conversion quartz glass layer is reduced. The heat treatment in the water vapor atmosphere eliminates the need for a heating furnace or the like, and enables manufacturing by a low-temperature process.

The average particle diameter of the fluorescent material particles to be used in the present invention is preferably from 0.1 µm to 20 µm. The average particle diameter is more preferably from 1 µm to 10 µm. When the fluorescent material particles have an average particle diameter of less than 0.1 µm, the surface areas thereof are increased, and along with this, light is more strongly scattered, resulting in a reduction in light emission intensity. In contrast, when the fluorescent material particles have a size exceeding 20 µm, the formed film has uneven light emission chromaticity and an uneven light emission intensity.

As the fluorescent material particles, fluorescent material particles that are excited by ultraviolet rays having a wavelength of from 200 nm to 400 nm and can convert the ultraviolet rays to visible light are preferred, and any marketed product commercially available can be used. Specific examples thereof include: Sr₁₀(PO₄)6Cl₂:Eu²⁺, CaS:Bi, CaSrS:Bi, and Ba₁₋ₐEuₐMgAl₁₀O₁₇ as a blue fluorescent material; ZnS:Cu,Al, Ba₂SiO₄:Eu, and ZnGe₂O₄:Eu as a green fluorescent material; Y₂O₂S:Eu³⁺, CaS:Eu, 3.5MgO·0.5MgF₂·GeO₂:Mn, and K₅Eu_{2.5}(WO₄) as a red fluorescent material.

The silica fine particles to be used in the present invention preferably have a composition of synthetic quartz glass particles. Such wavelength conversion synthetic quartz glass layer forms a dense silica film after the heat treatment. Accordingly, the utilization of the synthetic quartz glass particles as inorganic oxide particles in view of compatibility of refractive index and thermal expansion coefficient enables suppression of a color variation and cracks.

When such silica fine particles are incorporated into the wavelength conversion quartz glass layer, the silica fine particles each act as aggregate, and a film having a large thickness can be formed at one time without generation of cracks at the time of lamination of the wavelength conversion quartz glass layers.

The silica fine particles to be used in the present invention have an average particle diameter of from 1 nm to 100 nm. The average particle diameter is preferably from 3.0 nm to 80 nm, more preferably from 5.0 nm to 50 nm. When the silica fine particles have an average particle diameter of less than 1 nm, the particles themselves are difficult to obtain. Even if such particles are obtained, the particles immediately agglomerate owing to large surface energy. In contrast, when the silica fine particles have an average particle diameter exceeding 100 nm, light is scattered excessively strongly, resulting in a reduction in light utilization efficiency of an LED.

The silica fine particles to be used in the present invention each have a spherical shape and hydrophobicity. When a liquid containing the silica fine particles is applied onto the quartz glass base material to form a coating, the liquid needs to have flowability. When the silica fine particles to be used each do not have a spherical shape, the flowability of the liquid is lost, and the coating cannot be formed uniformly. In addition, by virtue of the hydrophobicity, the silica fine particles are well dispersed in the polysilazane-containing solution, and a film in which the silica fine particles are uniformly dispersed can be obtained.

The concentration of the silica fine particles is preferably as follows: the polysilazane-containing solution has a ratio between the total amount of polysilazane, the fluorescent material particles, and the silica fine particles and the silica fine particles of from 10:0.01 to 10:1 in terms of mass. That is, when the total amount of polysilazane, the fluorescent material particles, and the silica fine particles is defined as 10 parts by mass, the amount of the silica fine particles is preferably from 0.01 part by mass to 1 part by mass. The ratio between the total amount of polysilazane, the fluorescent material particles, and the silica fine particles and the silica fine particles is more preferably from 10:0.05 to 10:0.5 in terms of mass. When the concentration of the silica fine particles is too low, the act as aggregate is lost. When the concentration of the silica fine particles is too high, diffuse reflection is caused, resulting in a reduction in light extraction efficiency.

In the production of the wavelength conversion quartz glass layer, a perhydropolysilazane solution is preferably used as a polysilazane solution. When other silazane compounds or alkoxysilanes are utilized, cracks are generated owing to the presence of an organic functional group because the organic functional group is decomposed at the time of heating in a water vapor atmosphere. Further, perhydropolysilazane is free of an organic functional group, and hence enables water vapor firing at low temperature because perhydropolysilazane is converted to silica without providing energy for combusting an organic material. When perhydropolysilazane is fired in a water vapor atmosphere, perhydropolysilazane constructed only of Si, N, and H changes into quartz glass constructed of Si and O.

In the production of the wavelength conversion quartz glass layer, it is preferred that a coating liquid containing the polysilazane solution, the silica fine particles, and the fluorescent material particles is dried at a temperature of, for example, from 100°C to 200°C to vaporize most of an organic solvent, and then subjected to firing in a water vapor atmosphere. The production of the wavelength conversion quartz glass layer can be accomplished in a firing time period of from about 10 seconds to 30 minutes, while the firing time period depends on the thickness of the wavelength conversion quartz glass layer. For example, a wavelength conversion quartz glass layer having a thickness of 1 µm can be produced at 600°C: in a water vapor atmosphere in 10 seconds.

Perhydropolysilazane in the perhydropolysilazane solution as the polysilazane solution causes the following reaction.

(SiH₂NH)+2H₂O→SiO₂+NH₃+2H₂

The reaction proceeds to the right in the presence of water. Therefore, perhydropolysilazane can be converted to silica even in a short time period and at low temperature through heating in water vapor. In the firing of perhydropolysilazane in a water vapor atmosphere, a Si-N bond in its skeleton changes into a Si-O bond. At this time, the molecular weight of a basic structural unit increases, and hence a denser and harder film can be obtained.

The firing temperature for forming the wavelength conversion quartz glass layer in water vapor is preferably from 100°C to 1,000°C, more preferably from 200°C to 900°C. When the firing temperature is too high, the fluorescent material undergoes thermal deactivation, resulting in a reduction in light emission intensity. When the firing temperature is too low, the water vapor is not diffused inside, and the reaction is not caused sufficiently.

Herein, in the case of laminating the wavelength conversion quartz glass layers, the thickness per layer is preferably from 0.1 µm to 10 µm, more preferably from 0.5 µm to 10 µm, still more preferably from 0.5 µm to 5 µm. When the thickness per layer is less than 0.1 µm, it takes a long time to form the wavelength conversion quartz glass layers, resulting in an increase in manufacturing cost. In contrast, when a layer having a thickness exceeding 10 µm is formed at one time, cracks are generated at the time of the firing owing to generation of a H₂ gas resulting from the reaction. The wavelength conversion quartz glass layers are formed until the layers as a whole achieve such a thickness as to contain a desired amount of the fluorescent material by repeating such lamination treatment. Thus, the wavelength conversion quartz glass layer having a laminate structure and having a thickness of from 1 µm to 500 µm can be formed.

The wavelength conversion quartz glass layer having a laminate structure and having a thickness of from 1 µm up to 500 µm may be formed by repeating a plurality of times wavelength conversion quartz glass layer formation treatment of applying the polysilazane-containing solution onto the quartz glass base material, followed by drying in the air and then heating in a water vapor atmosphere at a temperature of 100°C or more and 600°C or less to form the wavelength conversion quartz glass layer having a thickness of from 0.1 µm to 10 µm. Perhydropolysilazane can reduce the number of times of formation treatment, simplify an operation, and realize a reduction in manufacturing cost, as compared to other materials. A wet coating method such as a spray method, a spin coating method, a dip coating method, or a roll coating method may be used for the formation of the wavelength conversion quartz glass layer.

The concentration of the fluorescent material particles in the wavelength conversion quartz glass layer is preferably as follows: the polysilazane-containing solution has a ratio between the total amount of polysilazane and the fluorescent material particles and the fluorescent material particles of from 10:3 to 10:7 in terms of mass. That is, when the total amount of polysilazane and the fluorescent material particles is defined as 10 parts by mass, the amount of the fluorescent material particles is preferably from 3 parts by mass to 7 parts by mass. In addition, the ratio between the total amount of polysilazane and the fluorescent material particles and the fluorescent material particles is more preferably from 10:5 to 10:7 in terms of mass.

When the concentration of the fluorescent material particles is low, the number of times of lamination needs to be increased accordingly, and hence the number of operation procedures is increased. When the concentration of the fluorescent material particles is too high, light from a light source hardly enters inside, resulting in a reduction in light emission efficiency. The concentration of NH groups remaining in the wavelength conversion quartz glass layer is 1,000 ppm or less, preferably 100 ppm or less. When the NH group concentration is equal to or less than the value, coloration does not occur and cracks are not generated even through long-term irradiation with ultraviolet rays or exposure to high temperature.

The thickness of the wavelength conversion quartz glass layer is preferably from 1 µm to 500 µm. The thickness of the wavelength conversion quartz glass layer is more preferably 10 µm or more and 100 µm or less. When the thickness is less than 1 µm, light from the light source is transmitted, resulting in a reduction in wavelength conversion efficiency. Besides, in the case of using ultraviolet rays as the light source, the harmful ultraviolet rays are radiated. On the other hand, when the thickness exceeds 500 µm, the number of times of lamination is increased, resulting in an increase in manufacturing cost.

In a second aspect of the wavelength conversion quartz glass layer preparing step to be used in the present invention, the wavelength conversion quartz glass layer is produced by a method including preparing a solution in which the fluorescent material particles and water are mixed in a TEOS hydrolysis solution, applying the solution onto the surface of the quartz glass base material, followed by drying and then heating.

More specifically, the wavelength conversion quartz glass layer is preferably prepared by a manufacturing method including the steps of: forming the wavelength conversion quartz glass layer on the surface of the quartz glass base material by applying, onto the quartz glass base material, a TEOS hydrolysis solution prepared by mixing fluorescent material particles having an average particle diameter of from 0.1 µm to 20 µm, water, and TEOS, followed by drying in the air; and forming the transparent coating film on the surface of the wavelength conversion quartz glass layer. In the method, the TEOS hydrolysis solution has a ratio between the total amount of TEOS and the fluorescent material particles and the fluorescent material particles of from 10:1 to 10:9 in terms of mass.

It is preferred that the wavelength conversion quartz glass layer having a laminate structure and having a thickness of from 1 µm up to 500 µm is formed by repeating a plurality of times wavelength conversion quartz glass layer formation treatment of applying the TEOS hydrolysis solution onto the quartz glass base material, followed by drying in the air and then heating at a temperature of 300°C or more and 1,000°C or less to form the wavelength conversion quartz glass layer having a thickness of from 0.1 µm to 10 µm.

It should be noted that the wavelength conversion quartz glass layers are preferably laminated so that the fluorescent material concentrations of the layers are adjusted from a high concentration to a low concentration from the quartz glass base material toward the transparent coating film.

It should be noted that it is preferred that the wavelength conversion quartz glass layer uses a plurality of kinds of fluorescent materials, and is formed by laminating a plurality of layers by using a different kind of fluorescent material for each of the layers.

The TEOS hydrolysis solution is prepared by mixing tetraethoxysilane, ethanol, and a trace amount of nitric acid, followed by stirring for about 1 hour. The TEOS hydrolysis solution preferably has a fraction in a range of: tetraethoxysilane (from 0.5 mol to 2 mol); ethanol (from 2 mol to 5 mol); and a trace amount of nitric acid (from 0.0005 mol to 0.01 mol).

The TEOS hydrolysis solution, fluorescent material fine particles similar to those described in the first aspect, and water are stirred with a homogenizer. The stirred solution is preferably in a range of: 1 mol to 4 mol of the TEOS hydrolysis solution; 0.5 mol to 3 mol of the fluorescent material fine particles; and 5 mol to 20 mol of water.

The stirred solution is applied onto the surface of the quartz glass base material to form a wavelength conversion quartz glass layer having a thickness of from 0.1 µm to 10 µm, preferably from 1 µm to 5 µm, and then dried at a temperature of from 0°C to 200°C, preferably from room temperature to 100°C in the air atmosphere. Then, this layer formation treatment is repeated a plurality of times, to form the wavelength conversion quartz glass layer having a laminate structure and having a thickness of from 1 µm to 500 µm, preferably from 10 µm up to 300 µm. The quartz glass member after the lamination is heated at a temperature of from 300°C to 1,000°C, preferably from 400°C to 900°C in the air.

When the layer formation treatment for the wavelength conversion quartz glass layer is repeated a plurality of times, a solution having a high fluorescent material concentration is used for a layer close to the surface of the quartz glass base material and a solution having a lower fluorescent material concentration is used as the number of times of lamination increases. Thus, the wavelength conversion quartz glass layer having a laminate structure is formed. The high-concentration layer close to the quartz glass base material has a high thermal conductivity, and hence can efficiently conduct heat from the quartz glass base material having high temperature in use and suppress heating. The low-concentration layer close to the surface has increased stability as quartz glass, and generation of cracks and particles due to the influence of heating or the external atmosphere is suppressed. When the total amount of silica and the fluorescent material particles in the formed wavelength conversion quartz glass layer is defined as 10 parts by mass, the amount of the fluorescent material particles is from 6 parts by mass to 9 parts by mass, preferably from 7 parts by mass to 9 parts by mass in the high-concentration layer close to the quartz glass base material, and the amount of the fluorescent material particles is from 1 part by mass to 5 parts by mass, preferably from 1 part by mass to 2 parts by mass in the low-concentration layer close to the surface.

When the lamination is performed by repeating the layer formation treatment for the wavelength conversion quartz glass layer a plurality of times, a plurality of layers are formed by preparing a solution containing a single fluorescent material for a single layer. With this, uniform fluorescent material distribution and uniform light emission are obtained in each layer, and the light emission intensity is uniformized in the whole surface of an outermost layer. When the layer formation treatment is performed by using a solution prepared by mixing different fluorescent materials, the fluorescent materials are liable to be distributed non-uniformly in the layer owing to a difference in specific gravity between the fluorescent materials, and the light emission intensity is not uniformized in an area of a surface layer.

### [Quartz Glass Base Material]

In the quartz glass member for wavelength conversion according to the third aspect of the present invention, a quartz glass base material similar to the quartz glass base material in the quartz glass member for wavelength conversion according to the second aspect of the present invention described above may be adopted as the quartz glass base material. In addition, a quartz glass base material preparing step for the quartz glass member for wavelength conversion according to the third aspect of the present invention is similar to the quartz glass base material preparing step for the quartz glass member for wavelength conversion according to the second aspect of the present invention described above.

### Examples

Now, the present invention is more specifically described by way of Examples. It goes without saying that Examples are given for illustrative purposes and should not be interpreted as limiting the present invention.

Examples and Comparative Examples of the quartz glass member for wavelength conversion according to the first aspect of the present invention are shown as Examples 1 to 10 and Comparative Examples 1 to 8.

### (Example 1)

5 g of a spherical fluorescent material to be excited by deep ultraviolet light (trade name: QKL65E/S-C1, manufactured by U-VIX Corporation, average particle diameter: 30 µm (measurement device: Micro Track MT3000, manufactured by Nikkiso Co., Ltd.)), 10 g of 2-methoxyethanol (viscosity: 1.71 mPa·s at 20°C, vapor pressure: 0.83 kP at 20°C), 30 g of large zirconia balls (diameter: 5 mm), and 15 g of small zirconia balls (diameter: 0.3 mm) were put in a 500 ml zirconia container, and mixed in a planetary ball mill at 250 rpm for 30 minutes×6 sets. Thus, a fluorescent material dispersion liquid was obtained. After that, 2-methoxyethanol was vaporized in a dry oven at 100°C for 5 hours in the air, and thereby a pulverized fluorescent material-1 having a particle diameter of from 1 µm to 10 µm (clump form, bulk density: 0.6 g/cm³, average particle diameter: 5 µm, minimum particle diameter: 1 µm, maximum particle diameter: 10 µm) was obtained by drying.

Next, the pulverized fluorescent material-1 was loaded in Torre Smile ANN120 (a dibutyl ether solution containing 20 mass% of polysilazane without a catalyst, manufactured by Sanwa Kagaku Corp.) (the ratio between the total amount of polysilazane and the fluorescent material particles and the fluorescent material particles was 10:5 in terms of mass), and the mixture was mixed with a homogenizer (rotational speed: 8,000 rpm) for 5 minutes. After that, 0.1 g of hydrophobic silicon dioxide (trade name: ADMANANO, manufactured by Admatechs Company Limited, spherical shape, bulk density: 0.8 g/cm³, average particle diameter: 10 nm, minimum particle diameter: 3 nm, maximum particle diameter: 15 nm, content in the polysilazane-containing solution: 0.5%) was mixed therein. Thus, a dispersion liquid-1 was obtained.

The dispersion liquid-1 was loaded in a spray bottle, and applied by spray coating onto a synthetic quartz glass base material-1 (thickness: 3 mm, 20 mm in length×20 mm in width, OH group concentration: 300 ppm, surface roughness Ra: 0.05 µm) in an environment of room temperature of 20°C and a humidity of 50% in the air so as to achieve a thickness of 5 µm or less. A spray pressure was set to 0.1 MPa, a spraying time period was set to 1 second, air was used as a gas, the size of liquid particles was set to 1.0 µm, a distance between the base material and the spray was set to 10 cm, and an angle with respect to the base material was set to 60°.

The obtained film was dried on a hot plate at 100°C for 10 minutes, and then subjected to heat treatment on a ceramic hot plate at 500°C for 30 minutes in the presence of water vapor in the air (air flow rate: 20 l/min, water vapor flow rate: 0.7 ml/min), followed by cooling to room temperature. Thus, an application film having a thickness of 1.5 µm (concentration of remaining NH groups: 100 ppm or less, light transmittance around 470 nm: from 60% to 80%) was obtained.

The application by spray coating was repeated 10 times under the same conditions as those described above. Thus, a quartz glass member for wavelength conversion of Example 1 (thickness: 12 µm, light transmittance around 470 nm: 5%, concentration of remaining NH groups: 100 ppm or less) was obtained.

### (Example 2)

A quartz glass member for wavelength conversion of Example 2 (thickness: 15 µm, light transmittance around 470 nm: 4%, concentration of remaining NH groups: 100 ppm or less) was produced in the same manner as in Example 1 except that the following pulverized fluorescent material-2 was used instead of the pulverized fluorescent material-1 used in Example 1.

The pulverized fluorescent material-2 (average particle diameter: 10 µm) was obtained in the same manner as in the preparation of the pulverized fluorescent material-1 except that a fluorescent material to be excited by near ultraviolet light (trade name: UVW365, manufactured by U-VIX Corporation) was used instead of the fluorescent material to be excited by ultraviolet light (trade name: QKL65E/S-C1, manufactured by U-VIX Corporation).

### (Example 3)

A quartz glass member for wavelength conversion of Example 3 was produced in the same manner as in Example 1 except that a natural quartz glass base material was used instead of the synthetic quartz glass base material-1 used in Example 1.

### (Example 4)

A quartz glass member for wavelength conversion of Example 4 (thickness: 15 µm, light transmittance around 470 nm: 4%, concentration of remaining NH groups: 100 ppm or less) was produced in the same manner as in Example 1 except that the following pulverized fluorescent material-3 was used instead of the pulverized fluorescent material-1 used in Example 1.

The pulverized fluorescent material-3 (average particle diameter: 1 µm) was obtained in the same manner as in Example 1 except that the mixing in the fluorescent material pulverization step for the pulverized fluorescent material-1 was performed in a planetary ball mill at 250 rpm for 30 minutes×12 sets.

### (Example 5)

A quartz glass member for wavelength conversion of Example 5 (thickness: 15 µm, light transmittance around 470 nm: 4%, concentration of remaining NH groups: 100 ppm or less) was produced in the same manner as in Example 1 except that the following pulverized fluorescent material-4 was used instead of the pulverized fluorescent material-1 used in Example 1.

The pulverized fluorescent material-4 (average particle diameter: 15 µm) was obtained in the same manner as in Example 1 except that the mixing in the fluorescent material pulverization step for the pulverized fluorescent material-1 was performed in a planetary ball mill at 250 rpm for 30 minutes×1 set.

### (Example 6)

A quartz glass member for wavelength conversion of Example 6 (thickness: 15 µm, light transmittance around 470 nm: 4%, concentration of remaining NH groups: 100 ppm or less) was produced in the same manner as in Example 1 except that hydrophobic and spherical silica fine particles having an average particle diameter of 10 nm were used instead of ADMANANO used in Example 1.

### (Example 7)

A quartz glass member for wavelength conversion of Example 7 (thickness: 15 µm, light transmittance around 470 nm: 4%, concentration of remaining NH groups: 100 ppm or less) was produced in the same manner as in Example 1 except that hydrophobic and spherical silica fine particles having an average particle diameter of 80 nm were used instead of ADMANANO used in Example 1.

### (Example 8)

A quartz glass member for wavelength conversion of Example 8 (thickness: 15 µm, light transmittance around 470 nm: 4%, concentration of remaining NH groups: 100 ppm or less) was produced in the same manner as in Example 1 except that the pulverized fluorescent material used in Example 1 was loaded at a ratio between the total amount of polysilazane and the fluorescent material particles and the fluorescent material particles of 10:4 in terms of mass.

### (Example 9)

A quartz glass member for wavelength conversion of Example 9 (thickness: 15 µm, light transmittance around 470 nm: 4%, concentration of remaining NH groups: 100 ppm or less) was produced in the same manner as in Example 1 except that the pulverized fluorescent material used in Example 1 was loaded at a ratio between the total amount of polysilazane and the fluorescent material particles and the fluorescent material particles of 10:6 in terms of mass.

### (Example 10)

A quartz glass member for wavelength conversion of Example 10 (thickness: 15 µm, light transmittance around 470 nm: 4%, concentration of remaining NH groups: 700 ppm) was produced in the same manner as in Example 1 except that the lamination was repeated by changing the heating temperature in water vapor in Example 1 to 300°C.

### (Comparative Example 1)

A quartz glass member for wavelength conversion of Comparative Example 1 was produced in the same manner as in Example 1 except that the heating in the heat treatment step, in which the film was heated at 500°C in water vapor after being dried at 100°C in Example 1, was performed at 500°C without utilizing water vapor.

### (Comparative Example 2)

A quartz glass member for wavelength conversion of Comparative Example 2 was produced in the same manner as in Example 1 except that Torre Smile ANP310 (terminal methylated silazane) was used instead of Torre Smile ANN120 used in Example 1.

### (Comparative Example 3)

A quartz glass member for wavelength conversion of Comparative Example 3 was produced in the same manner as in Example 1 except that the fluorescent material to be excited by deep ultraviolet light (average particle diameter: 30 µm) used in Example 1 was used without wet pulverization.

### (Comparative Example 4)

A quartz glass member for wavelength conversion of Comparative Example 4 was produced in the same manner as in Example 1 except that spherical and hydrophilic silicon dioxide (trade name: SE05, average particle diameter: 300 µm) was used instead of ADMANANO used in Example 1.

### (Comparative Example 5)

A quartz glass member for wavelength conversion of Comparative Example 5 was produced in the same manner as in Example 1 except that silicon dioxide having a network structure (trade name: AEROSIL 380, specific surface area: 380 cm²/g) was used instead of ADMANANO used in Example 1.

### (Comparative Example 6)

A quartz glass member for wavelength conversion of Comparative Example 6 was produced in the same manner as in Example 1 except that the pulverized fluorescent material used in Example 1 was loaded at a ratio between the total amount of polysilazane and the fluorescent material particles and the fluorescent material particles of 10:2 in terms of mass.

### (Comparative Example 7)

A quartz glass member for wavelength conversion of Comparative Example 7 was produced in the same manner as in Example 1 except that the pulverized fluorescent material used in Example 1 was loaded at a ratio between the total amount of polysilazane and the fluorescent material particles and the fluorescent material particles of 10:8 in terms of mass.

### (Comparative Example 8)

A quartz glass member for wavelength conversion of Comparative Example 8 was produced in the same manner as in Example 1 except that ADMANANO used in Example 1 was not used.

### (Evaluation)

The following evaluations were performed on all Examples and Comparative Examples.
- Visual observation
- Visual observation at the time of irradiation with ultraviolet rays of 254 nm
- NH group concentration measurement by X-ray fluorescence spectroscopy
- Dispersibility observation

In visual observation, the case where cracks or particles were observed was judged as "x". In visual observation at the time of irradiation with ultraviolet rays of 254 nm, the case where the intensity was low was judged as "x". X-ray fluorescence spectroscopy was performed for the purpose of examining the presence of an NH group. Dispersibility observation was performed by EDS measurement. The case where, in an EDS measurement area measuring 70 µm×50 µm, agglomerates of elements contained in the fluorescent material or agglomerates of Si element had a size of 5 µm or less was represented as "Pass". Regarding productivity, the case where the number of repetitions of application was 100 or less was represented as "Pass". The case where any one of the results of X-ray fluorescence spectroscopy, dispersibility observation, and productivity was "Failure" was judged as "x".

The quartz glass members produced in Examples 1 and 3 to 10 were each irradiated with a UV lamp having a light emission peak at 254 nm (0.6 mW/cm²). The quartz glass member produced in Example 2 was irradiated with a UV lamp having a light emission peak at 365 nm. The chromaticity was evaluated with a simplified spectrometer. The evaluation results are shown below.

**[Table 1]**

| Number of quartz glass member | Visual observation | Visual observation at time of irradiation with ultraviolet rays of 254 nm | NH group concentration | Dispersibility observation | Productivity | Judgment |
|---|---|---|---|---|---|---|
| Example 1 | Good | Good | <100 ppm | Pass | Pass | ○ |
| Example 2 | Good | Good | <100 ppm | Pass | Pass | ○ |
| Example 3 | Good | Colored | < 100 ppm | Pass | Pass | Δ |
| Example 4 | Good | Good | <100 ppm | Pass | Pass | ○ |
| Example 5 | Good | Good | <100 ppm | Pass | Pass | ○ |
| Example 6 | Good | Good | <100 ppm | Pass | Pass | ○ |
| Example 7 | Good | Good | <100 ppm | Pass | Pass | ○ |
| Example 8 | Good | Good | <100 ppm | Pass | Pass | ○ |
| Example 9 | Good | Good | <100 ppm | Pass | Pass | ○ |
| Example 10 | Good | Good | 700 ppm | Pass | Pass | ○ |
| Comparative Example 1 | Colored | Colored | 1,200 ppm | Pass | Pass | × |
| Comparative Example 2 | Crack | Colored | <100 ppm | Pass | Pass | × |
| Comparative Example 3 | Particle | Uneven | <100 ppm | Failure | Pass | × |
| Comparative Example 4 | Particle | Uneven | <100 ppm | Failure | Pass | × |
| Comparative Example 5 | Crack | Good | <100 ppm | Pass | Pass | × |
| Comparative Example 6 | Good | Good | <100 ppm | Pass | Failure | × |
| Comparative Example 7 | Particle | Uneven | <100 ppm | Failure | Pass | × |
| Comparative Example 8 | Crack | Good | < 100 ppm | Pass | Pass | × |

**[Table 2]**

| Number of quartz glass member | Chromaticity |
|---|---|
| Example 1 | x=0.330, y=0.303 |
| Example 2 | x=0.275, y=0.337 |
| Example 3 | x=0.310, y=0.207 |
| Example 4 | x=0.331, v=0.303 |
| Example 5 | x=0.329, y=0.303 |
| Example 6 | x=0.330, y=0.302 |
| Example 7 | x=0.331, y=0.301 |
| Example 8 | x=0.330, y=0.302 |
| Example 9 | x=0.331, y=0.300 |
| Example 10 | x=0.329, y=0.301 |

As seen from the results in Table 1, all examples other than Examples were judged as "×". Example 3 was judged as "Δ" because the base material itself was observed to emit light.

As seen from the results in Table 2, the state of the film was good and visible light was emitted in each of Examples 1 to 10 of the present invention (FIG. 2).

Next, Examples and Comparative Examples of the quartz glass member for wavelength conversion according to the second aspect of the present invention are shown as Examples 11 to 16 and Comparative Example 9.

### (Example 11)

5 g of a spherical fluorescent material to be excited by deep ultraviolet light (trade name: QKL65E/S-C1, Y₂O₂S-Tb, Eu, manufactured by U-VIX Corporation), 10 g of 2-methoxyethanol (viscosity: 1.71 mPa·s at 20°C, vapor pressure: 0.83 kP at 20°C), and 20 g of agate balls (diameter: 5 mm) were put in a 500 ml zirconia container, and mixed in a planetary ball mill at 250 rpm for 15 minutes×5 sets. Thus, a fluorescent material dispersion liquid was obtained. After that, 2-methoxyethanol was vaporized on a hot plate at 100°C for 1 hour in the air, and thereby a pulverized fluorescent material-1 having an average particle diameter of 5 µm (clump form, bulk density: 0.3 g/cm³ or more and 1.0 g/cm³ or less, minimum particle diameter: 1 µm, maximum particle diameter: 10 µm) was obtained by drying.

Next, the pulverized fluorescent material-1 was loaded in Torre Smile ANN120 (a dibutyl ether solution containing 20 mass% of polysilazane without a catalyst, manufactured by Sanwa Kagaku Corp.) (the ratio between the total amount of polysilazane and the fluorescent material particles and the fluorescent material particles was 50 parts by mass), and the mixture was mixed with a homogenizer (rotational speed: 8,000 rpm) for 5 minutes. After that, 0.1 g of hydrophobic silicon oxide (trade name: ADMANANO, manufactured by Admatechs Company Limited (spherical shape, bulk density: 0.4 g/cm³ or more and 1.5 g/cm³ or less, average particle diameter: 10 nm, minimum particle diameter: 3 nm, maximum particle diameter: 15 nm)) was mixed therein. Thus, a dispersion liquid-1 was obtained.

The dispersion liquid-1 was loaded in a spray bottle, and applied by spray coating onto a synthetic quartz glass base material-1 (thickness: 3 mm, 20 mm in length×20 mm in width, OH group concentration: 300 ppm, surface roughness Ra: 0.5 µm) in an environment of room temperature of 20°C and a humidity of 50% in the air so as to achieve a thickness of 5 µm or less. A spray pressure was set to 0.1 MPa, a spraying time period was set to 20 seconds, air was used as a gas, the size of liquid particles was set to 5 µm, a distance between the base material and the spray was set to 15 cm, and an angle with respect to the base material was set to 70°.

The obtained film was dried on a hot plate at 100°C for 10 minutes, and then subjected to heat treatment on a ceramic hot plate at 500°C for 30 minutes in the presence of water vapor in the air (air flow rate: 1 l/min, water vapor flow rate: 1.0 ml/min), followed by cooling to room temperature. Thus, an application film having a thickness of 2 µm (concentration of remaining NH groups: 100 ppm or less, light transmittance around 470 nm: 70%) was obtained.

The application by spray coating was repeated 20 times or less under the same conditions as those described above. Thus, a wavelength conversion quartz glass layer having a thickness of 15 µm, a light transmittance around 470 nm of 20%, and a concentration of remaining NH groups of 100 ppm or less was formed on a synthetic quartz glass base material.

Next, 5 g of titanium tetraisopropoxide (manufactured by Wako Pure Chemical Industries, Ltd.) and 10 g of isopropyl alcohol (manufactured by Junsei Chemical Co., Ltd.) were mixed, and stirred with a magnetic stirrer at a rotational speed of 400 rpm for 5 minutes. Then, a hydrochloric acid solution (1.5 g of 35% hydrochloric acid and 1 g of isopropyl alcohol) was added thereto in drops, to adjust the pH to about 2. After that, the solution was stirred at a rotational speed of 400 rpm for 30 minutes, and a solution prepared by mixing 16 g of pure water, 7 g of isopropyl alcohol, and 1 g of dimethylformamide (manufactured by Kanto Chemical Co., Inc.) was added thereto. The solution was stirred at a rotational speed of 400 rpm for 1 hour to perform hydrolysis, and thus a titanium oxide precursor was produced.

The titanium oxide precursor was loaded in a similar spray bottle to that as described above, and applied by spray coating onto the wavelength conversion quartz glass layer in an environment of room temperature of 20°C and a humidity of 50% in the air under the same spray conditions as in the case of the application film-2 so as to achieve a thickness of about 1 µm. After that, the resultant was dried on a hot plate at 100°C for 10 minutes, and then subjected to heat treatment on a hot plate at 550°C for 30 minutes in the air. Thus, a quartz glass member for wavelength conversion of Example 11 in which a transparent Ti-containing inorganic film was formed on the surface of the wavelength conversion quartz glass layer was produced.

### (Example 12)

The liquid was produced in the same manner as in Example 11, and the application films were formed in the same manner up to the tenth spray coating, and then formed by using liquids having proportionately reduced weight ratios of the fluorescent material in the subsequent spray coating up to the twentieth spray coating so that the application film on the surface was formed by using a liquid having a weight ratio of the fluorescent material of 0%. A quartz glass member for wavelength conversion was produced in the same manner as in Example 11 except for the foregoing.

### (Example 13)

A quartz glass member for wavelength conversion was produced in the same manner as in Example 11 except that a liquid containing a blue fluorescent material of Sr₁₀(PO₄)₆Cl₂:Eu²⁺ was used from the first to seventh spray coating, a liquid containing a green fluorescent material of ZnS:Cu,Al was used from the eighth to fourteenth spray coating, and a liquid containing a red fluorescent material of Y₂O₂S:Eu³⁺ was used from the fifteenth to twenty-first spray coating, while the liquids were produced in the same manner as in Example 11.

### (Example 14)

1 Mole of TEOS, 3 moles of ethanol, 0.002 mole of nitric acid were stirred for 5 minutes, and 10 moles of water was added thereto to produce a TEOS hydrolysis solution. 1 Mole of the same fluorescent material as that in Example 11 and 10 moles of water were added to 2 moles of the TEOS hydrolysis solution. The mixture was stirred with a homogenizer for 5 minutes. A film having a thickness of 1 µm was formed by spray coating in the same manner as in Example 11 except for the foregoing. After drying at 60°C, the films were repeatedly laminated 20 times, and then also the transparent layer was formed thereon. After that, the resultant was heated at 800°C for 2 hours in the air.

### (Example 15)

1 Mole of TEOS, 3 moles of ethanol, 0.002 mole of nitric acid were stirred for 5 minutes, and 10 moles of water was added thereto to produce a TEOS hydrolysis solution. 1 Mole of the same fluorescent material as that in Example 11 and 10 moles of water were added to 2 moles of the TEOS hydrolysis solution. The mixture was stirred with a homogenizer for 5 minutes. A film having a thickness of 1 µm was formed by spray coating. After drying at 60°C, the films were repeatedly laminated 20 times. After that, the resultant was heated at 800°C for 2 hours in the air. As the quartz base material, a base material formed of synthetic quartz glass containing 100 ppm of Cu was used.

### (Example 16)

The liquid was produced in the same manner as in Example 11, and the application films were formed in the same manner up to the fifteenth spray coating, and in the subsequent five times of spray coating, intermediate quartz glass layers each having a weight ratio of the fluorescent material particles reduced to half of the weight ratio of the fluorescent material particles in the wavelength conversion quartz glass layer were formed. Further, the same transparent layer as in Example 11 was formed on the surface. That is, as the intermediate quartz glass layer, an intermediate quartz glass layer having a concentration of fluorescent material particles of 50% of the concentration of the fluorescent material particles in the wavelength conversion quartz glass layer was formed. Opaque synthetic quartz glass having a bubble diameter of from 5 µm to 20 µm, an average diameter of 20 µm, and a bubble density of 1×10⁷ bubbles/cm³ was used for the quartz base material.

### (Comparative Example 9)

A quartz glass member for wavelength conversion was produced in the same manner as in Example 11 except that a member in which the wavelength conversion quartz glass layer was formed on the synthetic quartz glass base material was produced without forming the transparent coating film on the surface of the wavelength conversion quartz glass layer. The evaluations were performed in the same manner.

### (Evaluation)

The quartz glass members produced in Examples 11 to 16 and Comparative Example 9 were each irradiated with a UV lamp having a light emission peak at 254 nm (0.6 mW/cm²). Light transmitted through the member was evaluated for chromaticity and a spectral spectrum with a spectrometer.

**[Table 3]**

| Number of quartz glass member | State of film surface | Chromaticity |
|---|---|---|
| Example 11 | good | x=0.376, y=0.354 |
| Example 12 | good | x=0.367, y=0.349 |
| Example 13 | good | x=0.377, y=0.359 |
| Example 14 | good | x=0.371, v=0.350 |
| Example 15 | good | x=0.375, y=0.349 |
| Example 16 | good | x=0.378, y=0.351 |
| Comparative Example 9 | Generation of particles | x=0.347, y=0.319 |

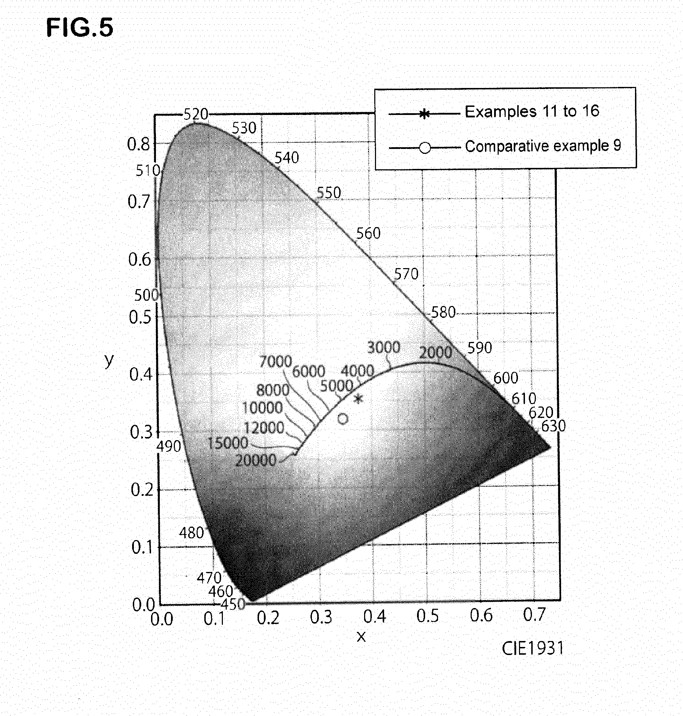

As seen from the results in Table 3, the state of the film was good and visible light was emitted in each of Examples 11 to 16 of the present invention. (FIG. 5: Chromaticity diagram)

Further, as seen from the results of the spectral spectrum of light transmitted through the members, a spectral intensity was significantly reduced in an ultraviolet wavelength region of 340 nm or less as compared to that in the case of the member without the Ti-containing inorganic film. (FIG. 6: Spectral spectrum)

Further, X-ray diffraction measurement was performed on a surface layer of the Ti-containing inorganic film in Example 11, and a diffraction peak of an anatase-type Ti crystal was confirmed.

Next, Examples and Comparative Example of the quartz glass member for wavelength conversion according to the third aspect of the present invention are shown as Examples 17 to 20 and Comparative Example 10.

### (Experimental Example 1)

5 g of a spherical fluorescent material to be excited by deep ultraviolet light (trade name: QKL65E/S-C1, Y₂O₂S-Tb, Eu, manufactured by U-VIX Corporation), 10 g of 2-methoxyethanol (viscosity: 1.71 mPa·s at 20°C, vapor pressure: 0.83 kP at 20°C), and 20 g of agate balls (diameter: 5 mm) were put in a 500 ml zirconia container, and mixed in a planetary ball mill at 250 rpm for 15 minutes×5 sets. Thus, a fluorescent material dispersion liquid was obtained. After that, 2-methoxyethanol was vaporized on a hot plate at 100°C for 1 hour in the air, and thereby a pulverized fluorescent material-1 having an average particle diameter of 5 µm (clump form, bulk density: 0.3 g/cm³ or more and 1.0 g/cm³ or less, minimum particle diameter: 1 µm, maximum particle diameter: 10 µm) was obtained by drying.

Next, the pulverized fluorescent material-1 was loaded in Torre Smile ANN120 (a dibutyl ether solution containing 20 mass% of polysilazane without a catalyst, manufactured by Sanwa Kagaku Corp.) (the ratio between the total amount of polysilazane and the fluorescent material particles and the fluorescent material particles was 50 parts by mass), and the mixture was mixed with a homogenizer (rotational speed: 8,000 rpm) for 5 minutes. After that, 0.1 g of hydrophobic silicon oxide (trade name: ADMANANO, manufactured by Admatechs Company Limited (spherical shape, bulk density: 0.4 g/cm³ or more and 1.5 g/cm³ or less, average particle diameter: 10 nm, minimum particle diameter: 3 nm, maximum particle diameter: 15 nm)) was mixed therein. Thus, a dispersion liquid-1 was obtained.

The dispersion liquid-1 was loaded in a spray bottle, and applied by spray coating onto a synthetic quartz glass base material-1 (thickness: 3 mm, 20 mm in lengthx20 mm in width, OH group concentration: 300 ppm, surface roughness Ra: 0.5 µm) in an environment of room temperature of 20°C and a humidity of 50% in the air so as to achieve a thickness of 5 µm or less. A spray pressure was set to 0.1 MPa, a spraying time period was set to 20 seconds, air was used as a gas, the size of liquid particles was set to 5 µm, a distance between the base material and the spray was set to 15 cm, and an angle with respect to the base material was set to 70°.

The obtained film was dried on a hot plate at 100°C for 10 minutes, and then subjected to heat treatment on a ceramic hot plate at 500°C for 30 minutes in the presence of water vapor in the air (air flow rate: 1 l/min, water vapor flow rate: 1.0 ml/min), followed by cooling to room temperature. Thus, an application film having a thickness of 2 µm (concentration of remaining NH groups: 100 ppm or less, light transmittance around 470 nm: 70%) was obtained.

The application by spray coating was repeated 20 times or less under the same conditions as those described above. Thus, a wavelength conversion quartz glass layer having a thickness of 15 µm, a light transmittance around 470 nm of 20%, and a concentration of remaining NH groups of 100 ppm or less was formed on a synthetic quartz glass base material.

Next, 5 g of titanium tetraisopropoxide (manufactured by Wako Pure Chemical Industries, Ltd.) and 10 g of isopropyl alcohol (manufactured by Junsei Chemical Co., Ltd.) were mixed, and stirred with a magnetic stirrer at a rotational speed of 400 rpm for 5 minutes. Then, a hydrochloric acid solution (1.5 g of 35% hydrochloric acid and 1 g of isopropyl alcohol) was added thereto in drops, to adjust the pH to about 2. After that, the solution was stirred at a rotational speed of 400 rpm for 30 minutes, and a solution prepared by mixing 16 g of pure water, 7 g of isopropyl alcohol, and 1 g of dimethylformamide (manufactured by Kanto Chemical Co., Inc.) was added thereto. The solution was stirred at a rotational speed of 400 rpm for 1 hour to perform hydrolysis, and thus a titanium oxide precursor was produced.

The titanium oxide precursor was loaded in a similar spray bottle to that as described above, and applied by spray coating onto the wavelength conversion quartz glass layer in an environment of room temperature of 20°C and a humidity of 50% in the air under the same spray conditions as in the case of the application film-2 so as to achieve a thickness of about 1 µm. After that, the resultant was dried on a hot plate at 100°C for 10 minutes, and then subjected to heat treatment on a hot plate at 550°C for 30 minutes in the air. Thus, a quartz glass member for wavelength conversion of Experimental Example 1 in which a transparent Ti-containing inorganic film was formed on the surface of the wavelength conversion quartz glass layer was produced.

### (Example 17)

The liquid was produced in the same manner as in Experimental Example 1, and the application films were formed in the same manner up to the tenth spray coating, and then formed by using liquids having proportionately reduced weight ratios of the fluorescent material in the subsequent spray coating up to the twentieth spray coating so that the application film on the surface was formed by using a liquid having a weight ratio of the fluorescent material of 0%. A quartz glass member for wavelength conversion was produced in the same manner as in Experimental Example 1 except for the foregoing.

### (Example 18)

A quartz glass member for wavelength conversion was produced in the same manner as in Experimental Example 1 except that the application films were formed by using a liquid containing a blue fluorescent material of Sr₁₀(PO₄)₆Cl₂:Eu²⁺, a liquid containing a green fluorescent material of ZnS:Cu,Al, and a liquid containing a red fluorescent material of Y₂O₂S:Eu³⁺ in this order up to the ninth spray coating in the same manner as in Experimental Example 1, and then formed by using liquids having proportionately reduced concentrations of the fluorescent material after the tenth spray coating so that the application film on the outermost surface was formed by using a liquid having a weight ratio of the fluorescent material of 0%, while the liquids were produced in the same manner as in Experimental Example 1.

### (Example 19)

1 Mole of TEOS, 3 moles of ethanol, and 0.002 mole of nitric acid were stirred for 5 minutes, and 10 moles of water was added thereto to produce a TEOS hydrolysis solution. 1 Mole of the fluorescent material and 10 moles of water were added to 2 moles of the TEOS hydrolysis solution in the same manner as in Experimental Example 1. The mixture was stirred with a homogenizer for 5 minutes. A film having a thickness of 1 µm was formed by spray coating. After drying at 60°C, the films were repeatedly laminated 20 times in the same manner as in Experimental Example 1, and then the resultant was heated at 800°C for 2 hours in the air.

### (Example 20)

A quartz glass member for wavelength conversion was produced in the same manner as in Example 17 except that the liquid was produced in the same manner as in Example 17, and the application films were formed in the same manner up to the fifteenth spray coating, and in the subsequent five times of spray coating, intermediate quartz glass layers each having a weight ratio of the fluorescent material particles reduced to half of the weight ratio of the fluorescent material particles in the wavelength conversion quartz glass layer in the fourteenth spray coating were formed. That is, as the intermediate quartz glass layer, an intermediate quartz glass layer having a concentration of fluorescent material particles of 50% of the concentration of the fluorescent material particles in the wavelength conversion quartz glass layer was formed.

### (Comparative Example 10)

A quartz glass member for wavelength conversion was produced in the same manner as in Experimental Example 1 except that a member in which the wavelength conversion quartz glass layer was formed on the synthetic quartz glass base material was produced without forming the transparent coating film on the surface of the wavelength conversion quartz glass layer. The evaluations were performed in the same manner.

### (Evaluation)

The quartz glass members produced in Examples 17, 18, 19, and 20 and Comparative Example 10 were each irradiated with a UV lamp having a light emission peak at 254 nm (0.6 mW/cm²). Light transmitted through the member was evaluated for chromaticity and a spectral spectrum with a spectrometer.

**[Table 4]**

| Number of quartz glass member | State of film surface | Ratio between light emission intensities | Chromaticity |
|---|---|---|---|
| Experimental Example 1 | Good | 1.0 | x=0.376, y=0.354 |
| Example 17 | Good | 2.0 | x=0.367, y=0.349 |
| Example 18 | Good | 2.2 | x=0.377, y=0.359 |
| Example 19 | Good | 2.3 | x=0.371, y=0.350 |
| Example 20 | Good | 1.9 | x=0.375, y=0.349 |
| Comparative Example 10 | Generation of particles | 1.0 | x=0.347, y=0.319 |

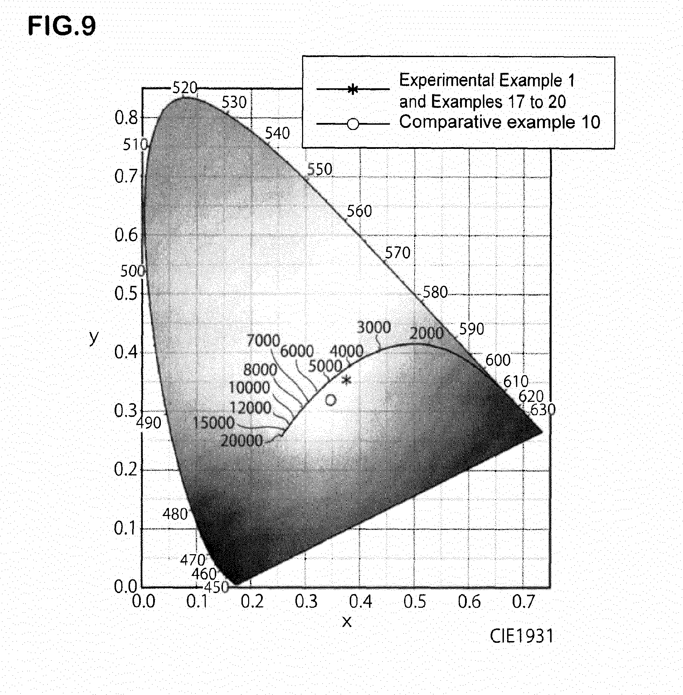

As seen from the results in Table 4, the state of the film was good and visible light was emitted in each of Examples 17 to 20 of the present invention. (FIG. 9: Chromaticity diagram)

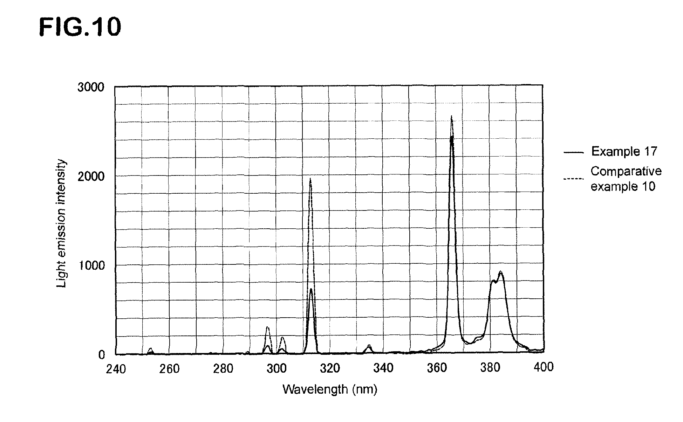

Further, as seen from the results of the spectral spectrum of light transmitted through the members, a spectral intensity was significantly reduced in an ultraviolet wavelength region of 340 nm or less as compared to that in the case of the member without the Ti-containing inorganic film. (FIG. 10: Spectral spectrum)

Further, X-ray diffraction measurement was performed on a surface layer of the Ti-containing inorganic film in Example 17, and a diffraction peak of an anatase-type Ti crystal was confirmed.

### Reference Signs List

10: quartz glass member for wavelength conversion according to first aspect of present invention, 12, 32, 52: quartz glass base material, 14: quartz glass surface layer film, 16, 36, 56: fluorescent material particle, 18, 38, 58: silica fine particle, 30A, 30B: quartz glass member for wavelength conversion according to second aspect of present invention, 34, 54: wavelength conversion quartz glass layer, 40, 60: transparent coating film, 42, 62: intermediate quartz glass layer, 50A, 50B: quartz glass member for wavelength conversion according to third aspect of present invention.

## Claims

1. A quartz glass member for wavelength conversion, comprising:
a quartz glass base material; and
a quartz glass surface layer film formed on a surface of the quartz glass base material, wherein:
the quartz glass surface layer film is obtained by applying, onto the surface of the quartz glass base material, a polysilazane-containing solution containing fluorescent material particles having an average particle diameter of from 0.1 µm to 20 µm and silica fine particles each having a spherical shape and hydrophobicity and having an average particle diameter of from 1 nm to 100 nm, followed by drying in air and then heat treatment in a water vapor atmosphere;
the polysilazane-containing solution has a ratio between a total amount of polysilazane and the fluorescent material particles and the fluorescent material particles of from 10:3 to 10:7 in terms of mass; and
the quartz glass surface layer film has an NH group concentration of 1,000 ppm or less.

2. A quartz glass member for wavelength conversion according to claim 1, wherein quartz glass to be used in the quartz glass base material comprises synthetic quartz glass.

3. A method of manufacturing a quartz glass member for wavelength conversion, the method comprising:
forming a quartz glass surface layer film on a surface of a quartz glass base material by applying, onto the quartz glass base material, a polysilazane-containing solution containing fluorescent material particles having an average particle diameter of from 0.1 µm to 20 µm and 0.1 mass% to 10 mass% of silica fine particles each having a spherical shape and hydrophobicity and having an average particle diameter of from 1 nm to 100 nm, followed by heating in a water vapor atmosphere,
the polysilazane-containing solution having a ratio between a total amount of polysilazane and the fluorescent material particles and the fluorescent material particles of from 10:3 to 10:7 in terms of mass.

4. A method of manufacturing a quartz glass member for wavelength conversion according to claim 3,
wherein the forming a quartz glass surface layer film comprises repeating a plurality of times quartz glass surface layer film formation treatment of applying the polysilazane-containing solution onto the quartz glass base material, followed by drying in air and then heating in a water vapor atmosphere at a temperature of from 100°C to 600°C to form a quartz glass surface layer film having a thickness of from 0.1 µm to 10 µm, to form the quartz glass surface layer film having a laminate structure and having a thickness of from 1 µm to 500 µm.

5. A quartz glass member for wavelength conversion, comprising:
a quartz glass base material;
a wavelength conversion quartz glass layer formed on a surface of the quartz glass base material, the wavelength conversion quartz glass layer containing fluorescent material particles; and
a transparent coating film formed on a surface of the wavelength conversion quartz glass layer.

6. A quartz glass member for wavelength conversion according to claim 5, wherein the transparent coating film comprises a transparent inorganic film.

7. A quartz glass member for wavelength conversion according to claim 6, wherein the transparent inorganic film comprises a Ti-containing inorganic film.

8. A quartz glass member for wavelength conversion according to claim 7, wherein the Ti-containing inorganic film contains titanium oxide in an anatase crystal form.

9. A quartz glass member for wavelength conversion according to any one of claims 5 to 8, further comprising an intermediate quartz glass layer formed between the wavelength conversion quartz glass layer and the transparent coating film, the intermediate quartz glass layer having a concentration of fluorescent material particles of approximately from 10% to 60% of a concentration of the fluorescent material particles in the wavelength conversion quartz glass layer.

10. A quartz glass member for wavelength conversion according to any one of claims 5 to 9, wherein the quartz glass base material comprises synthetic quartz glass.

11. A quartz glass member for wavelength conversion according to any one of claims 5 to 10, wherein the quartz glass base material comprises quartz glass containing one or more selected from the group consisting of Ga, Ce, Cu, and Ti.

12. A quartz glass member for wavelength conversion according to any one of claims 5 to 10, wherein the quartz glass base material comprises light scattering quartz glass having micro bubbles and/or a micro interface.

13. A method of manufacturing the quartz glass member for wavelength conversion of any one of claims 5 to 12, the method comprising:
forming the transparent coating film by applying, onto the surface of the wavelength conversion quartz glass layer or a surface of the intermediate quartz glass layer, a solution containing silica and/or a silica precursor to form a thin film coating, followed by drying and then heating.

14. A method of manufacturing the quartz glass member for wavelength conversion according to claim 13, wherein the transparent coating film and the wavelength conversion quartz glass layer are each formed by a sol-gel method.

15. A method of manufacturing the quartz glass member for wavelength conversion according to claim 13, the method comprising the steps of
forming the wavelength conversion quartz glass layer on the surface of the quartz glass base material by applying, onto the quartz glass base material, a polysilazane-containing solution containing fluorescent material particles having an average particle diameter of from 0.1 µm to 20 µm and silica fine particles each having a spherical shape and hydrophobicity and having an average particle diameter of from 1 nm to 100 nm, followed by drying in air and then heat treatment in a water vapor atmosphere; and
forming the transparent coating film on the surface of the wavelength conversion quartz glass layer,
the polysilazane-containing solution having a ratio between a total amount of polysilazane and the fluorescent material particles and the fluorescent material particles of from 10:1 to 10:9 in terms of mass,
the wavelength conversion quartz glass layer having an NH group concentration of 1,000 ppm or less.

16. A method of manufacturing the quartz glass member for wavelength conversion according to claim 13 or 14, the method comprising the steps of:
forming the wavelength conversion quartz glass layer on the surface of the quartz glass base material by applying, onto the quartz glass base material, a TEOS hydrolysis solution prepared by mixing fluorescent material particles having an average particle diameter of from 0.1 µm to 20 µm, water, and TEOS, followed by drying in air; and
forming the transparent coating film on the surface of the wavelength conversion quartz glass layer,
the TEOS hydrolysis solution having a ratio between a total amount of TEOS and the fluorescent material particles and the fluorescent material particles of from 10:1 to 10:9 in terms of mass.

17. A method of manufacturing the quartz glass member for wavelength conversion of any one of claims 7 to 12, the method comprising:
forming the Ti-containing inorganic film by applying, onto the surface of the wavelength conversion quartz glass layer, a solution containing Ti to form a coating, followed by sintering.

18. A quartz glass member for wavelength conversion, comprising:
a quartz glass base material; and
a wavelength conversion quartz glass layer formed on a surface of the quartz glass base material, the wavelength conversion quartz glass layer containing fluorescent material particles,
wherein the wavelength conversion quartz glass layer has a fluorescent material concentration distributed from a high concentration to a low concentration from a glass base material side toward a wavelength conversion quartz glass layer surface side.

19. A quartz glass member for wavelength conversion according to claim 18, wherein the wavelength conversion quartz glass layer has a laminate structure, contains a plurality of kinds of fluorescent materials, and is formed by laminating a plurality of layers by using a different kind of fluorescent material for each of the plurality of layers.

20. A quartz glass member for wavelength conversion according to claim 18 or 19, wherein the quartz glass base material comprises synthetic quartz glass.

21. A quartz glass member for wavelength conversion according to any one of claims 18 to 20, wherein the quartz glass base material comprises quartz glass containing one or more selected from the group consisting of Ga, Ce, Cu, and Ti.

22. A quartz glass member for wavelength conversion according to any one of claims 18 to 21, wherein the quartz glass base material comprises light scattering quartz glass having micro bubbles and/or a micro interface.

23. A quartz glass member for wavelength conversion according to any one of claims 18 to 22, further comprising a transparent coating film formed on the surface of the wavelength conversion quartz glass layer.

24. A quartz glass member for wavelength conversion according to claim 23, wherein the transparent coating film comprises a transparent inorganic film.

25. A quartz glass member for wavelength conversion according to claim 24, wherein the transparent inorganic film comprises a Ti-containing inorganic film.

26. A quartz glass member for wavelength conversion according to claim 25, wherein the Ti-containing inorganic film contains titanium oxide in an anatase crystal form.

27. A quartz glass member for wavelength conversion according to any one of claims 23 to 26, further comprising an intermediate quartz glass layer formed between the wavelength conversion quartz glass layer and the transparent coating film, the intermediate quartz glass layer having a concentration of fluorescent material particles of approximately from 10% to 60% of a concentration of the fluorescent material particles in the wavelength conversion quartz glass layer.

28. A method of manufacturing the quartz glass member for wavelength conversion of any one of claims 23 to 27, the method comprising:
forming the transparent coating film by applying a solution containing silica and/or a silica precursor to form a thin film coating, followed by drying and then heating.

29. A method of manufacturing the quartz glass member for wavelength conversion according to claim 28, wherein the transparent coating film and the wavelength conversion quartz glass layer are each formed by a sol-gel method.

30. A method of manufacturing the quartz glass member for wavelength conversion according to claim 28 or 29, the method comprising:
forming the Ti-containing inorganic film by applying, onto the surface of the wavelength conversion quartz glass layer, a solution containing Ti to form a coating, followed by sintering.

31. A method of manufacturing the quartz glass member for wavelength conversion of any one of claims 18 to 27, the method comprising the steps of:
forming the wavelength conversion quartz glass layer on the surface of the quartz glass base material by applying, onto the quartz glass base material, a polysilazane-containing solution containing fluorescent material particles having an average particle diameter of from 0.1 µm to 20 µm and silica fine particles each having a spherical shape and hydrophobicity and having an average particle diameter of from 1 nm to 100 nm, followed by drying in air and then heat treatment in a water vapor atmosphere; and
further forming a transparent coating film on a surface of the wavelength conversion quartz glass layer,
the polysilazane-containing solution having a ratio between a total amount of polysilazane and the fluorescent material particles and the fluorescent material particles of from 10:1 to 10:9 in terms of mass,
the wavelength conversion quartz glass layer having an NH group concentration of 1,000 ppm or less.

32. A method of manufacturing the quartz glass member for wavelength conversion according to claim 31,
wherein the forming the quartz conversion glass surface layer comprises repeating a plurality of times wavelength conversion quartz glass layer formation treatment of applying the polysilazane-containing solution onto the quartz glass base material, followed by drying in air and then heating in a water vapor atmosphere at a temperature of from 100°C to 600°C to form a wavelength conversion quartz glass layer having a thickness of from 0.1 µm to 10 µm, to form the wavelength conversion quartz glass layer having a laminate structure and having a thickness of from 1 µm up to 500 µm.

33. A method of manufacturing the quartz glass member for wavelength conversion of any one of claims 18 to 27, the method comprising the steps of:
forming the wavelength conversion quartz glass layer on the surface of the quartz glass base material by preparing a solution in which the fluorescent material particles having an average particle diameter of from 0.1 µm to 20 µm and water are mixed in a TEOS hydrolysis solution, followed by applying the solution onto the quartz glass base material and then drying in air; and
forming a transparent coating film on a surface of the wavelength conversion quartz glass layer,
the TEOS hydrolysis solution having a ratio between a total amount of TEOS and the fluorescent material particles and the fluorescent material particles of from 10:1 to 10:9 in terms of mass.

34. A method of manufacturing the quartz glass member for wavelength conversion according to claim 33,
wherein the forming the wavelength conversion quartz glass layer comprises repeating a plurality of times wavelength conversion quartz glass layer formation treatment of applying the TEOS hydrolysis solution onto the quartz glass base material, followed by drying in air and then heating at 300°C to 1,000°C to form a wavelength conversion quartz glass layer having a thickness of from 0.1 µm to 10 µm, to form the wavelength conversion quartz glass layer having a laminate structure and having a thickness of from 1 µm up to 500 µm.

35. A method of manufacturing the quartz glass member for wavelength conversion according to any one of claims 28 to 34, wherein the wavelength conversion quartz glass layer is formed by laminating layers so that fluorescent material concentrations of the layers are adjusted from a high concentration to a low concentration from the quartz glass base material toward the transparent coating film.

36. A method of manufacturing the quartz glass member for wavelength conversion according to any one of claims 28 to 34, wherein the wavelength conversion quartz glass layer contains a plurality of kinds of fluorescent materials, and is formed by laminating a plurality of layers by using a different kind of fluorescent material for each of the plurality of layers.
